(19) Europäisches Patentamt
European Patent Office
Office européen des brevets

(11) EP 4 550 784 A1

(12) EUROPEAN PATENT APPLICATION

(43) Date of publication:
07.05.2025 Bulletin 2025/19

(51) International Patent Classification (IPC):
H04N 19/13 (2014.01)    H03M 7/30 (2006.01)
H03M 7/40 (2006.01)    H04N 19/91 (2014.01)

(21) Application number: 24203465.0

(22) Date of filing: 30.09.2024

(52) Cooperative Patent Classification (CPC):
H04N 19/13; H03M 7/3079; H03M 7/40;
H03M 7/4018; H04N 19/91

(84) Designated Contracting States:
AL AT BE BG CH CY CZ DE DK EE ES FI FR GB
GR HR HU IE IS IT LI LT LU LV MC ME MK MT NL
NO PL PT RO RS SE SI SK SM TR
Designated Extension States:
BA
Designated Validation States:
GE KH MA MD TN

(30) Priority: 01.11.2023 US 202363595235 P
19.12.2023 US 202318545569

(71) Applicant: INTEL Corporation
Santa Clara, CA 95054 (US)

(72) Inventors:
• Moccagatta, Iole
San Jose CA, 95132 (US)
• Alshin, Alexander
129323 Moscow (RU)
• Yakovenko, Andrey
129323 Moscow (RU)
• Goncharenko, Miroslav
81479 Munich (DE)
• Aristarkhov, Vasily
39112 Magdeburg (DE)

(74) Representative: Samson & Partner Patentanwälte
mbB
Widenmayerstraße 6
80538 München (DE)

(54) **PROBABILITY ESTIMATION IN MULTI-SYMBOL ENTROPY CODING WITH TWO ESTIMATORS**

(57) Entropy coding, such as multi-symbol arithmetic coding, is used in video compression to encode data into a compressed bit stream for transmission. Some entropy coding techniques are adaptive, meaning that the probability distribution is updated on the fly, based on the data. Accuracy of cumulative probability estimation in adaptive multi-symbol arithmetic coding can impact coding efficiency. To address the issue, a mixture of two or more adaptive cumulative probability estimations computed using two or more adaptation parameters can be used in place of a single cumulative probability estimate. The two or more adaptation parameters can be unique for a context model. A divergence in the adaptive cumulative probability estimations may signal a sudden change in the probability of a symbol. The divergence may trigger a reset of one or more adaptive cumulative probability estimations.

UPDATE PROBABILITY DISTRIBUTION 612

FOR i=0,...,N-1

CHECK i<VAL OR i≥VAL 802

DETERMINE CDFNEW1[i] USING RATE 1 804

DETERMINE CDFNEW2[i] USING RATE 2 806

COMBINE 808

UPDATE TABLE 810

FIG. 8

EP 4 550 784 A1

**Description**

<u>Background</u>

Video compression is a technique for making video files smaller and easier to transmit over the Internet. There are different methods and algorithms for video compression, with different performance and tradeoffs. Video compression involves encoding and decoding. Encoding is the process of transforming (uncompressed) video data into a compressed format. In some cases, some information is lost through encoding. Decoding is the process of restoring video data from the compressed format.

<u>Brief Description of the Drawings</u>

Embodiments will be readily understood by the following detailed description in conjunction with the accompanying drawings. To facilitate this description, like reference numerals designate like structural elements. Embodiments are illustrated by way of example, and not by way of limitation, in the figures of the accompanying drawings.

Figure (FIG.) 1 illustrates an encoding system and a plurality of decoding systems, according to some embodiments of the disclosure.

FIG. 2 illustrates an exemplary encoder to encode video frames and output an encoded bitstream, according to some embodiments of the disclosure.

FIG. 3 illustrates an exemplary decoder to decode an encoded bitstream and output a decoded video, according to some embodiments of the disclosure.

FIG. 4 illustrates probability estimation using exponential smoothing after initialization and after convergence, according to some embodiments of the disclosure.

FIG. 5 illustrates an exponential mesh of probabilities, according to some embodiments of the disclosure.

FIG. 6 illustrates an exemplary multi-symbol arithmetic coding technique implemented in an entropy coding process, according to some embodiments of the disclosure.

FIG. 7 illustrates interval subdivision for dictionary size N=4, according to some embodiments of the disclosure.

FIG. 8 illustrates updating probability distribution for adaptive multi-symbol arithmetic coding, according to some embodiments of the disclosure.

FIG. 9 depicts a first plot plotting two probability estimates and a mixture of the two probability estimates, according to some embodiments of the disclosure.

FIG. 10 depicts a second plot plotting two probability estimates and a mixture of the two probability estimates, according to some embodiments of the disclosure.

FIG. 11 illustrates updating probability distribution for adaptive multi-symbol arithmetic coding with resetting, according to some embodiments of the disclosure.

FIG. 12 illustrates updating probability distribution for adaptive multi-symbol arithmetic coding with state-dependent adaptation, according to some embodiments of the disclosure.

FIG. 13 illustrates updating probability distribution for adaptive multi-symbol arithmetic coding with state-dependent adaptation, according to some embodiments of the disclosure.

FIG. 14 illustrates updating probability distribution for adaptive multi-symbol arithmetic coding with variance-dependent adaptation, according to some embodiments of the disclosure.

FIG. 15 depicts a flow diagram of an exemplary method for adaptive multi-symbol arithmetic coding, according to some embodiments of the disclosure.

FIG. 16 depicts a block diagram of an exemplary computing device, according to some embodiments of the disclosure.

<u>Detailed Description</u>

*Overview*

Effective video compression allows for storage, sharing, and streaming of high-quality videos without consuming too much storage space and bandwidth. Video compression reduces the amount of data needed to represent a video by removing redundant or unnecessary information, such as repeated frames or sounds. Video compression can produce a compressed bitstream that is smaller and easier to manage than the original video data.

Effective video compression can enable users to have a smooth and seamless viewing experience when streaming video content over the Internet, without buffering or lagging issues. Improvements in video compression may be driven by the ever increasing demand for online video content, such as content from social media, entertainment content, education content, and communication content. Improvements in video compression may be driven by new types of video content that are being transmitted (e.g., gaming content, computer-generated graphics content, three-dimensional content, etc.).

One exemplary architecture of video compression is block-based video encoding. Block-based video encoding can reduce the size and bitrate of video data by dividing or partitioning each frame of the video into small blocks of pixels and encoding the blocks separately. Techniques applied to each block may include motion estimation, inter-frame prediction, intra-frame prediction, transformation, scaling, quantization, in-loop filtering. The resulting information of the blocks may then be encoded into a compressed bitstream by an entropy coder.

Entropy coding, such as binary arithmetic coding and multi-symbol arithmetic coding, can be used in video compression to encode data into a compressed bit stream for transmission. Arithmetic coding techniques may recursively subdivide an interval according to a probability distribution and use a final subinterval or a value in the final subinterval to encode the original data. The final subinterval or the value in the final subinterval may allow the original data to be unambiguously recovered.

Some arithmetic coding techniques are adaptive, meaning that the probability distribution can be updated on the fly, based on the data. For adaptive multi-symbol arithmetic coding, a sequence of symbols having more than two possible symbol values can be encoded into an encoded bitstream. The sequence of symbols can be compressed by assigning different subintervals of an interval to each possible symbol value, depending on the probability distribution of the sequence of symbols to be encoded. Different kinds or types of sequence of symbols may correspond to different context models, e.g., different probability distributions. The probability distributions may include cumulative probability estimates of the symbol values. The cumulative probability estimates may be updated using an adaptation parameter, such as an exponential smoothing parameter. An adaptation parameter can control a speed (e.g., how quickly) at which a cumulative probability estimate updates or changes as symbols are observed and encoded. An adaptation parameter can modify how much weight to give to a memory of a probability estimate (e.g., past observations of symbols) when a probability estimate is updated. An adaptation parameter can be a timing constant.

Starting with an interval, multi-symbol arithmetic coding may subdivide the interval into subintervals according to the cumulative probability estimates of the probability distribution. A subinterval corresponding to a current symbol in the sequence of symbols may be selected and renormalized. The renormalization process may cause one or more bits to be written to the encoded bitstream. The cumulative probability estimates of the probability distribution may be updated based on the observation of the current symbol.

The selected subinterval may be subdivided into further subintervals according to updated cumulative probability estimates. A further subinterval may be selected for the next current symbol in the sequence of symbols. The further subinterval may be renormalized, which may cause one or more bits to be written to the encoded bitstream. The process may continue recursively for the further subinterval and additional symbols in the sequence of symbols.

The cumulative probability estimates in the probability distribution are used for subdividing the interval, which then may impact the one or bits to be written to the encoded bitstream. In arithmetic coding, the smaller the subinterval, the more bits are used to encode the symbol. The more accurate the cumulative probability estimates, the more accurate the sizes of the subintervals become. The more accurate the sizes of the subintervals, the higher the coding efficiency becomes. The cumulative probability estimates impact coding efficiency because they impact how well the encoder and decoder can represent the sequence of symbols with the minimum number of bits.

Accuracy of cumulative probability estimates in the probability distribution in adaptive multi-symbol arithmetic coding can impact coding efficiency. The resulting encoded bitstream may have a higher bitrate when cumulative probability estimates in the probability distribution do not accurately reflect the true probability distribution of the different symbol values in the sequence of symbols. The accuracy of cumulative probability estimates may depend on how quickly the cumulative probability estimates adapt to observations of symbols. Adaptation of the cumulative probability estimates may adapt to changing statistics of the source symbols over time. Fast adaptation may quickly respond to changes in the statistics of the symbol values. Fast adaptation can quickly react to probability changes and quickly converge to an optimal value. However, if probability is not changing or is relatively stable, then variance of probability estimation may be high, which can lead to suboptimal coding. Slow adaptation may maintain a stable and reliable estimate that is closer to a global mean but cannot react quickly to changes in probability.

To address the issue, a mixture of two or more adaptive cumulative probability estimations computed using two or more adaptation parameters can be used in place of a single cumulative probability estimate. Using two or more adaptive cumulative probability estimations can balance the pros and cons of fast adaptation and slow adaptation. A (final) cumulative probability estimate may include a sum of the two or more cumulative probability estimates, e.g., as a weighted sum of these cumulative probability estimates. A first cumulative probability estimator may have a small value for an exponential smoothing parameter $\alpha$, which can give a cumulative probability estimation that is close to the global mean value. A second estimator may have a big value for the exponential smoothing parameter $\alpha$, which can quickly change if probability changes. Simultaneous usage of two or more estimates can allow for tradeoffs, which may allow the model to quickly react to probability changes and provide precise estimation when the probability is stable. By using two (or more) estimators, cumulative probability estimation in multi-symbol arithmetic coding and the resulting coding efficiency can be improved.

In some embodiments, the improved entropy encoding engine may include probability estimation based on a mixture of probability estimates with different update parameters, e.g., smoothing parameters or exponential smoothing parameters. This approach may take into account: one cumulative probability estimator which may be close to the global mean value, and another cumulative probability estimator which may react to changes (only) in a few recently encoded bins. This approach may allow quick adaptation to probability changes, as well as staying close to the global mean value.

The two or more different cumulative probability estimates may be updated using different rates or parameters, and the updating of the cumulative probability estimates may exhibit different properties. One cumulative probability estimate may have high or fast adaptation. Another cumulative probability estimate may have a low or slow adaptation. The two or more different cumulative probabilities estimates, when being mixed or combined, may have different weights corresponding to the two or more different cumulative probability estimates. The weights may change depending on the number of updates made to the probability distributions. The weights may change depending on how the probability estimates change. The weights may change depending on one or more factors. The weights may change based on context.

Cumulative probability estimates of symbol values for different kinds or types of sequence of symbols may exhibit more stable regions or may change a lot, depending on the kinds or types of sequence of symbols (e.g., the context model). The two or more adaptation parameters for the two or more cumulative probability estimators can be unique or specific for the probability distribution, e.g., a context model. The corresponding weights used in combining the cumulative probability estimators can be unique or specific for the probability distribution, e.g., a context model.

If the cumulative probability of a symbol suddenly changes, the cumulative probability estimation computed using a fast adaptation parameter may quickly react to the change and the cumulative probability estimation computed using a slow adaptation parameter may remain close to the previous value for a little while longer. The difference between the two cumulative probability estimations may dramatically increase. Using this insight, it is possible to modify the adaptation process to give more weight to the adaptive cumulative probability estimation computed using a fast adaptation parameter. In some cases, a divergence in the adaptive cumulative probability estimations may signal a sudden change in the probability of a symbol. The divergence may trigger a change in adaptation behavior, such as a reset of one or more adaptive cumulative probability estimations. A reset may clear the memory. A reset may reset a counter. A reset may change the adaptation rate. A reset may restart adaptation in response to the sudden change in probability of the symbol.

Besides a reset of one or more estimations, adaptation behavior can be changed or modified in one or more other ways. The weights for combining the adaptive cumulative probability estimates can toggle between different values to increase or decrease a particular adaptive cumulative probability estimate's contribution to the combined adaptive cumulative probability estimate. A particular adaptive cumulative probability estimate's contribution can be increased if a condition is detected, and the condition may indicate that a change may improve the accuracy of the combined cumulative probability estimate. In some embodiments, how much adaptive cumulative probability estimations diverge from each other can indicate a state of the probability distribution, e.g., whether the probability is changing or staying steady. If the state indicates the probability distribution is changing, contributions of the adaptive cumulative probability estimations can be adjusted to optimize accuracy. In some embodiments, variances of the adaptive cumulative probability estimates can indicate a state of the probability distribution.

Probability estimation used in one or more entropy coding techniques can benefit from using two or more different cumulative probability estimates for the derivation of a probability distribution for an alphabet of symbols. Entropy coding engine can be improved by including more precise estimations for cumulative probabilities in a multi-symbol entropy coding scheme (e.g., a multi-symbol arithmetic coding scheme), which can be used in codecs such as AV1 (AOMedia Video 1). The new entropy coding engine may have some improvement over the performance of the entropy coding engine specified in, e.g., AV1. AV1 is a video coding format (or codec) designed for video transmissions over the Internet. "AV1 Bitstream & Decoding Process Specification" version 1.1.1 with Errata was last modified on 2019-01-18.

The approach may be applicable to techniques that involve multi-symbol arithmetic coding and/or interval subdivision (e.g., dividing an interval into three or more subintervals) with using points on a cumulative distribution function (CDF). The approach may be applied in video codecs. The approach may be applied in a coding scheme where multi-symbol entropy coding is performed with an estimation of symbol probability on the fly. Probability distribution estimation using two or more different cumulative probability estimates as described in more detail herein may have one or more technical advantages, such as high accuracy, low complexity, a hardware-friendly implementation or design. Implementations involving probability distribution estimation using two or more different cumulative probability estimates as described in more detail herein may have one or more technical properties, such as high accuracy, elegant algorithm, integer operations, and parallelism. In some embodiments, the update of points of a CDF has low hardware complexity since it is multiplication-free. Hardware chips implementing this entropy code solution can have improved performance due to better thermal properties of the hardware chips.

*Video compression*

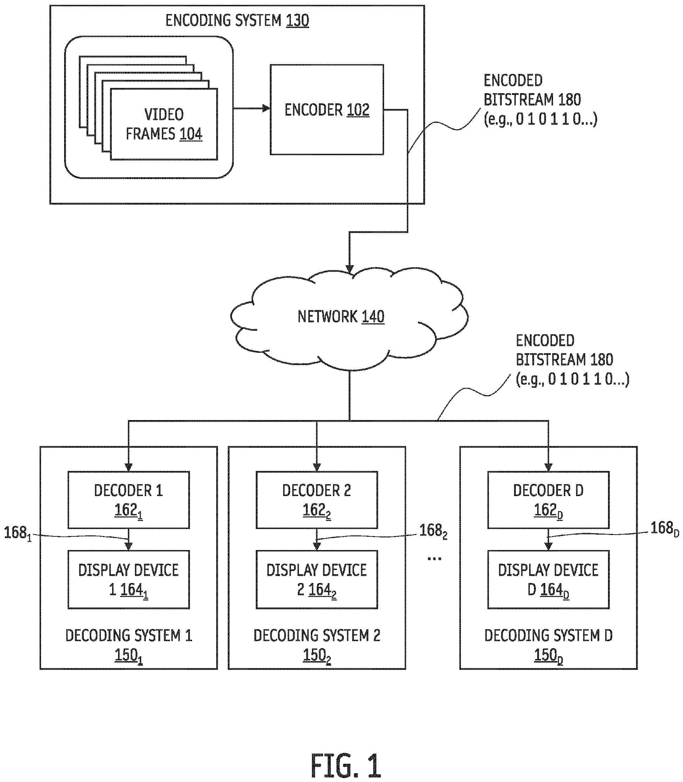

FIG. 1 illustrates encoding system 130 and one or more decoding systems $150_{1...D}$, according to some embodiments of the disclosure.

Encoding system 130 may be implemented on computing device 1600 of FIG. 1600. Encoding system 130 can be implemented in the cloud or in a data center. Encoding system 130 can be implemented on a device that is used to capture the video. Encoding system 130 can be implemented on a standalone computing system. Encoding system 130 may perform the process of encoding in video compression. Encoding system 130 may receive a video (e.g., uncompressed video, original video, raw video, etc.) comprising a sequence of video frames 104. The video frames 104 may include image frames or images that make up the video. A video may have a frame rate or number of frames per second (FPS), that defines the number of frames per second of video. The higher the FPS, the more realistic and fluid the video looks. Typically, FPS is greater than 24 frames per second for a natural, realistic viewing experience to a human viewer. Examples of video may include a television episode, a movie, a short film, a short video (e.g., less than 15 seconds long), a video capturing gaming experience, computer screen content, video conferencing content, live event broadcast content, sports content, a surveillance video, a video shot using a mobile computing device (e.g., a smartphone), etc. In some cases, video may include a mix or combination of different types of video.

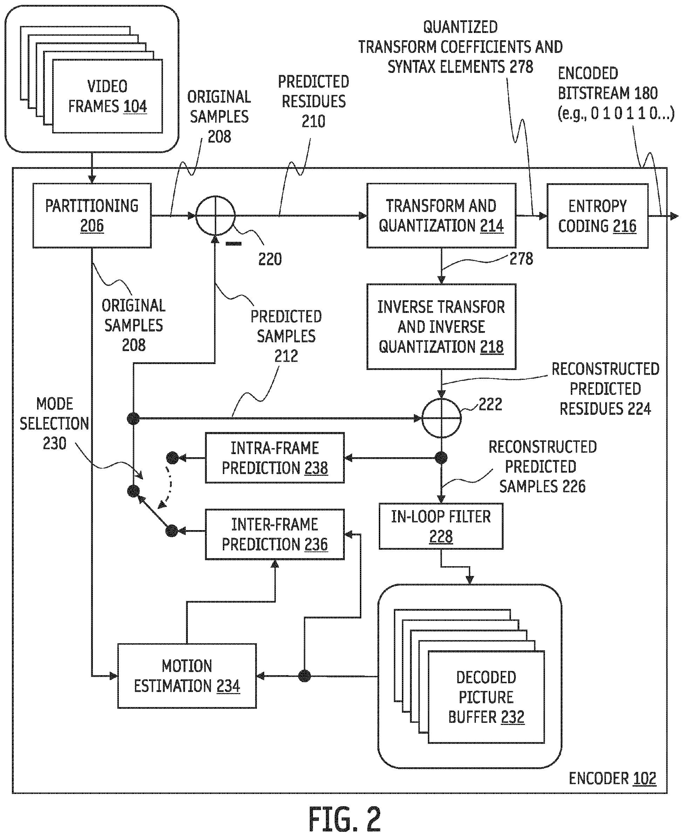

Encoding system 130 may include encoder 102 that receives video frames 104 and encodes video frames 104 into encoded bitstream 180. An exemplary implementation of encoder 102 is illustrated in FIG. 2.

Encoded bitstream 180 may be compressed, meaning that encoded bitstream 180 may be smaller in size than video frames 104. Encoded bitstream 180 may include a series of bits, e.g., having 0's and 1's. Encoded bitstream 180 may have header information, payload information, and footer information, which may be encoded as bits in the bitstream. Header information may provide information about one or more of: the format of encoded bitstream 180, the encoding process implemented in encoder 102, the parameters of encoder 102, and metadata of encoded bitstream 180. For example, header information may include one or more of: resolution information, frame rate, aspect ratio, color space, etc. Payload information may include data representing content of video frames 104, such as samples frames, symbols, syntax elements, etc. For example, payload information may include bits that encode one or more of motion predictors, transform coefficients, prediction modes, and quantization levels of video frames 104. Footer information may indicate an end of the encoded bitstream 180. Footer information may include other information including one or more of: checksums, error correction codes, and signatures. Format of encoded bitstream 180 may vary depending on the specification of the encoding and decoding process, i.e., the codec.

Encoded bitstream 180 may be transmitted to one or more decoding systems $150_{1...D}$, via network 140. Network 140 may be the Internet. Network 140 may include one or more of: cellular data networks, wireless data networks, wired data networks, cable Internet networks, fiber optic networks, satellite Internet networks, etc.

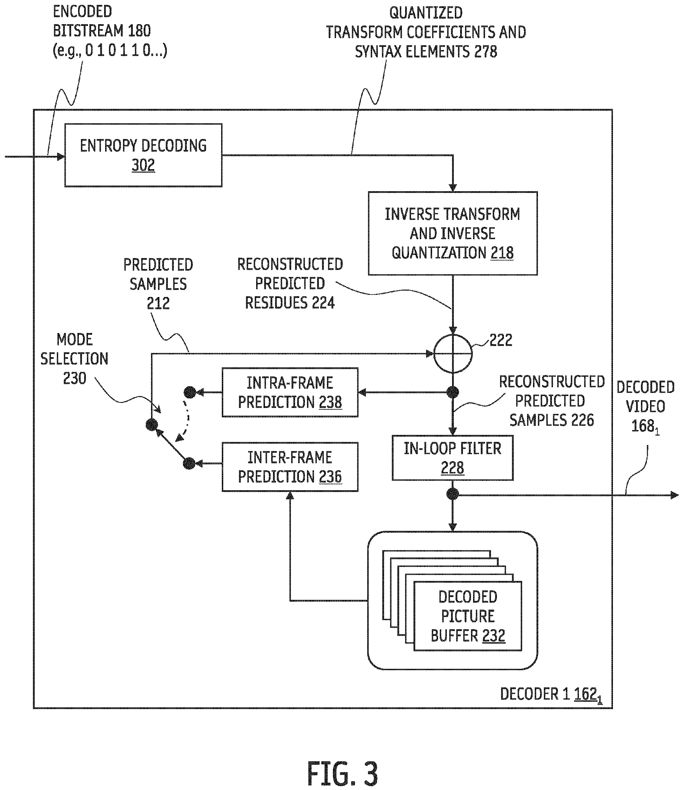

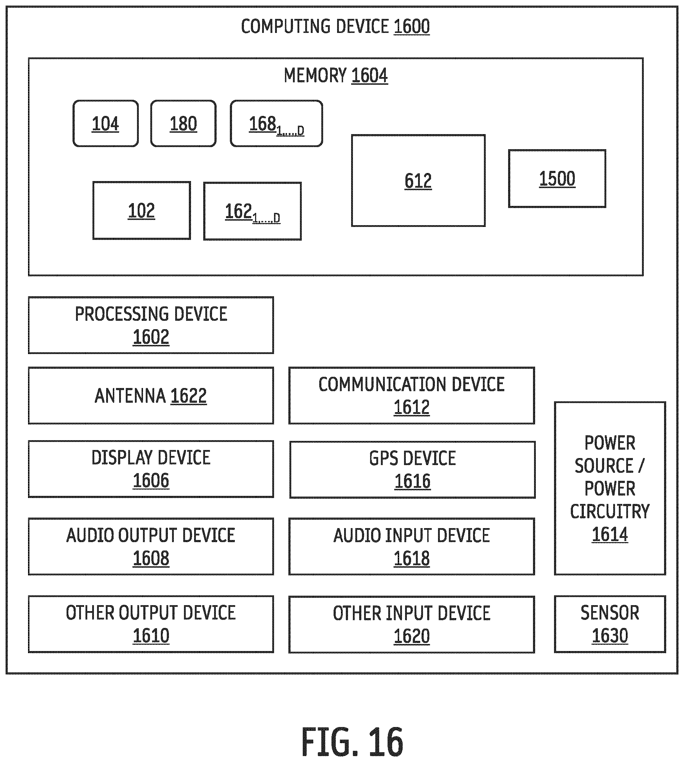

D number of decoding systems $150_{1...D}$ are illustrated. At least one of the decoding systems $150_{1...D}$ may be implemented on computing device 1600 of FIG. 16. Examples of systems $150_{1...D}$ may include personal computers, mobile computing devices, gaming devices, augmented reality devices, mixed reality devices, virtual reality devices, televisions, etc. Each one of decoding systems $150_{1...D}$ may perform the process of decoding in video compression. Each one of decoding systems $150_{1...D}$ may include a decoder (e.g., decoder 1...D $162_{1...D}$), and one or more display devices (e.g., display device 1...D $164_{1...D}$). An exemplary implementation of a decoder, e.g., decoder 1 $162_1$, is illustrated in FIG. 3.

For example, decoding system 1 $150_1$, may include decoder 1 $162_1$ and a display device 1 $164_1$. Decoder 1 $162_1$ may implement a decoding process of video compression. Decoder 1 $162_1$ may receive encoded bitstream 180 and produce decoded video $168_1$. Decoded video $168_1$ may include a series of video frames, which may be a version or reconstructed version of video frames 104 encoded by encoding system 130. Display device 1 $164_1$ may output the decoded video $168_1$ for display to one or more human viewers or users of decoding system 1 $150_1$.

*Video encoder*

FIG. 2 illustrates encoder 102 to encode video frames and output an encoded bitstream, according to some embodiments of the disclosure. Encoder 102 may include one or more of: signal processing operations and data processing operations, including inter and intra-frame prediction, transform, quantization, in-loop filtering, and entropy coding. Encoder 102 may include a reconstruction loop involving inverse quantization, and inverse transformation to guarantee that the decoder would see the same reference blocks and frames. Encoder 102 may receive video frames 104 and encodes video frames 104 into encoded bitstream 180. Encoder 102 may include one or more of partitioning 206, transform and quantization 214, inverse transform and inverse quantization 218, in-loop filter 228, motion estimation 234, inter-frame prediction 236, intra-frame prediction 238, and entropy coding 216.

Partitioning 206 may divide a frame in video frames 104 into blocks of pixels. Different codecs may allow different variable range of block sizes. In one codec, a frame may be partitioned by partitioning 206 into superblocks of size 128x128 or 64x64 pixels. Partitioning 206 may further divide each superblock using a multi-way partition tree structure. In some cases, a partition of a superblock can be recursively divided further by partitioning 206 using the multi-way partition tree structure (e.g., down to 4x4 size blocks). In another codec, a frame may be partitioned by partitioning 206 into coding tree units of size 128x128 pixels. Partitioning 206 may divide a coding tree unit using a quadtree partitioning structure into four coding units. Partitioning 206 may further recursively divide a coding unit using the quadtree partitioning structure. Partitioning 206 may (further) subdivide a coding unit using a multi-type tree structure (e.g., a quadtree, a binary tree, or ternary tree structure). A smallest coding unit may have a size of 4x4. In some codecs, coding units of luma pixels may be subdivided into smaller coding units (e.g., performing more tree structure subdivisions) than coding units of chroma pixels (e.g., stopping tree structure subdivision earlier). Partitioning 206 may output original samples 208, e.g., as blocks of pixels.

Intra-frame prediction 238 may predict samples of a block from reconstructed predicted samples of previously encoded spatial neighboring blocks of the same frame. Intra-frame prediction 238 may receive reconstructed predicted samples 226 (of previously encoded spatial neighbor blocks of the same frame). Reconstructed predicted samples 226 may be generated by summer 222 from reconstructed predicted residues 224 and predicted samples 212. Intra-frame prediction 238 may determine a suitable predictor for predicting the samples from reconstructed predicted samples of previously encoded spatial neighboring blocks of the same frame. Intra-frame prediction 238 may generate predicted samples 212 generated using the suitable predictor. Intra-frame prediction 238 may output or identify the neighboring block and a predictor used in generating the predicted samples 212. The identified neighboring block and predictor may be encoded in the encoded bitstream 180 to enable a decoder to reconstruct a block using the same neighboring block and predictor. In one codec, intra-frame prediction 238 may support a number of diverse predictors, e.g., 56 different predictors. Some predictors, e.g., directional predictors, may capture different spatial redundancies in directional textures. Pixel values of a block can be predicted using a directional predictor in intra-frame prediction 238 by extrapolating pixel values of a neighboring block along a certain direction. Intra-frame prediction 238 of different codecs may support different sets of predictors to exploit different spatial patterns within the same frame. Examples of predictors may include direct current (DC), planar, Paeth, smooth, smooth vertical, smooth horizontal, recursive-based filtering modes, chroma-from-luma, intra block copy, color palette, multiple-reference line, intra sub-partition, matrix-based intra prediction (matrix coefficients may be defined by offline training using neural networks), wide-angle prediction, cross-component linear model, template matching, etc.

Motion estimation 234 and inter-frame prediction 236 may predict samples of a block from samples of previously encoded frames, e.g., reference frames in decoded picture buffer 232. Motion estimation 234 may receive original samples 208 from partitioning 206. Motion estimation 234 may receive samples from decoded picture buffer 232 (e.g., samples of previously encoded frames or reference frames). Motion estimation 234 may use a number of reference frames for determining one or more suitable motion predictors. Motion predictors may include motion vectors that capture the movement of blocks between frames in a video. Motion estimation 234 may output or identify one or more reference frames and one or more suitable motion predictors. Inter-frame prediction 236 may apply the one or more suitable motion predictors determined in motion estimation 234 and one or more reference frames to generate predicted samples 212. The identified reference frame(s) and motion predictor(s) may be encoded in the encoded bitstream 180 to enable a decoder to reconstruct a block using the same reference frame(s) and motion predictor(s). In one codec, motion estimation 234 may implement single reference frame prediction mode, where a single reference frame with a corresponding motion predictor is used for inter-frame prediction 236. Motion estimation 234 may implement compound reference frame prediction mode where two reference frames with two corresponding motion predictors are used for inter-frame prediction 236. In one codec, motion estimation 234 may implement techniques for searching and identifying good reference frame(s) that can yield the most efficient motion predictor. The techniques in motion estimation 234 may include searching for good reference frame(s) candidates spatially (within the same frame) and temporally (in previously encoded frames). The techniques in motion estimation 234 may include searching a deep spatial neighborhood to find a spatial candidate pool. The techniques in motion estimation 234 may include utilizing temporal motion field estimation mechanisms to generate a temporal candidate pool. The techniques in motion estimation 234 may use a motion field estimation process. After temporal and spatial candidates may be ranked and a suitable motion predictor may be determined. In one codec, inter-frame prediction 236 may support a number of diverse motion predictors. Examples of predictors may include geometric motion vectors (complex, non-linear motion), warped motion compensation (affine transformations that capture non-translational object movements), overlapped block motion compensation, advanced compound prediction (compound wedge prediction, difference-modulated masked prediction, frame distance-based compound prediction, and compound inter-intra prediction), dynamic spatial and temporal motion vector referencing, affine motion compensation (capturing higher-order motion such as rotation, scaling, and sheering), adaptive motion vector resolution modes, geometric partitioning modes, bidirectional optical flow, prediction refinement with optical flow, bi-prediction with weights, extended merge prediction, etc.

Mode selection 230 may be informed by components such as motion estimation 234 to determine whether inter-frame prediction 236 or intra-frame prediction 238 may be more efficient for encoding a block.

Transform and quantization 214 may receive predicted residues 210. Predicted residues 210 may be generated by subtractor 220 that takes original samples 208 and subtracts predicted samples 212 to output predicted residues 210. Predicted residues 210 may be referred to as prediction error of the intra-frame prediction 238 and inter-frame prediction 236 (e.g., error between the original samples and predicted samples 212). Prediction error has a smaller range of values than the original samples and can be coded with fewer bits in encoded bitstream 180. Transform and quantization 214 may include one or more of transforming and quantizing. Transforming may include converting the predicted residues 210 from the spatial domain to the frequency domain. Transforming may include applying one or more transform kernels. Examples of transform kernels may include horizontal and vertical forms of discrete cosine transforms (DCT), asymmetrical discrete sine transform (ADST), flip ADST, and identity transform (IDTX), multiple transform selection, low-frequency non-separatable transform, sub-block transform, non-square transforms, DCT-VIII, discrete sine transform VII (DST-VII), discrete wavelet transform (DWT), etc. Transforming may convert the predicted residues 210 into transform coefficients. Quantizing may quantize the transformed coefficients, e.g., by reducing the precision of the transform coefficients. Quantizing may include using quantization matrices (e.g., linear and non-linear quantization matrices). The elements in the quantization matrix can be larger for higher frequency bands and smaller for lower frequency bands, which means that the higher frequency coefficients are more coarsely quantized, and the lower frequency coefficients are more finely quantized. Quantizing may include dividing each transform coefficient by a corresponding element in the quantization matrix and rounding to the nearest integer. Effectively, the quantization matrices may implement different quantization parameters (QPs) for different frequency bands and chroma planes and can use spatial prediction. A suitable quantization matrix can be selected and signaled for each frame and encoded in encoded bitstream 180. Transform and quantization 214 may output quantized transform coefficients and syntax elements 278 that indicate the coding modes and parameters used in the encoding process implemented in encoder 102.

Inverse transform and inverse quantization 218 may apply the inverse operations performed in transform and quantization 214 to produce reconstructed predicted residues 224 as part of a reconstruction path to produce decoded picture buffer 232 for encoder 102. Inverse transform and inverse quantization 218 may receive quantized transform coefficients and syntax elements 278. Inverse transform and inverse quantization 218 may perform one or more inverse quantization operations, e.g., applying an inverse quantization matrix, to obtain the unquantized/original transform coefficients. Inverse transform and inverse quantization 218 may perform one or more inverse transform operations, e.g., inverse transform (e.g., inverse DCT, inverse DWT, etc.), to obtain reconstructed predicted residues 224. A reconstruction path is provided in encoder 102 to generate reference blocks and frames, which are stored in decoded picture buffer 232. The reference blocks and frames may match the blocks and frames to be generated in the decoder. The reference blocks and frames are used as reference blocks and frames by motion estimation 234, inter-frame prediction 236, and intra-frame prediction 238.

In-loop filter 228 may implement filters to smooth out artifacts introduced by the encoding process in encoder 102 (e.g., processing performed by partitioning 206 and transform and quantization 214). In-loop filter 228 may receive reconstructed predicted samples 226 from summer 222 and output frames to decoded picture buffer 232. Examples of filters may include constrained low-pass filter, directional deringing filter, edge-directed conditional replacement filter, loop restoration filter, Wiener filter, self-guided restoration filters, constrained directional enhancement filter, luma mapping with chroma scaling, sample adaptive offset filter, adaptive loop filter, cross-component adaptive loop filter, etc.

Entropy coding 216 may receive quantized transform coefficients and syntax elements 278 (e.g., referred to herein as symbols) and perform entropy coding. Entropy coding 216 may generate and output encoded bitstream 180. Entropy coding 216 may exploit statistical redundancy and apply lossless algorithms to encode the symbols and produce a compressed bitstream, e.g., encoded bitstream 180. Entropy coding 216 may implement some version of arithmetic coding. Different versions may have different pros and cons. In one codec, entropy coding 216 may implement (symbol to symbol) adaptive multi-symbol arithmetic coding. In another codec, entropy coding 216 may implement context-based adaptive binary arithmetic coder (CABAC). Binary arithmetic coding differs from multi-symbol arithmetic coding. Binary arithmetic coding encodes only a bit at a time, e.g., having either a binary value of 0 or 1. Binary arithmetic coding may first convert each symbol into a binary representation (e.g., using a fixed number of bits per-symbol). Handling just binary value of 0 or 1 can simplify computation and reduce complexity. Binary arithmetic coding may assign a probability to each binary value (e.g., a chance of the bit having a binary value of 0 and a chance of the bit having a binary value of 1). Multi-symbol arithmetic coding performs encoding for an alphabet having at least two or three symbol values and assigns a probability to each symbol value in the alphabet. Multi-symbol arithmetic coding can encode more bits at a time, which may result in a fewer number of operations for encoding the same amount of data. Multi-symbol arithmetic coding can require more computation and storage (since probability estimates may be updated for every element in the alphabet). Maintaining and updating probabilities (e.g., cumulative probability estimates) for each possible symbol value in multi-symbol arithmetic coding can be more complex (e.g., complexity grows with alphabet size). Multi-symbol arithmetic coding is not to be confused with binary arithmetic coding, as the two different entropy coding processes are implemented differently and can result in different encoded bitstreams for the same set of quantized transform coefficients and syntax elements 278.

*Video encoder*

FIG. 3 illustrates decoder 1 $162_1$ to decode an encoded bitstream and output a decoded video, according to some embodiments of the disclosure. Decoder 1 $162_1$ may include one or more of: signal processing operations and data processing operations, including entropy decoding, inverse transform, inverse quantization, inter and intra-frame prediction, in-loop filtering, etc. Decoder 1 $162_1$ may have signal and data processing operations that mirror the operations performed in the encoder. Decoder 1 $162_1$ may apply signal and data processing operations that are signaled in encoded bitstream 180 to reconstruct the video. Decoder 1 $162_1$ may receive encoded bitstream 180 and generate and output decoded video $168_1$ having a plurality of video frames. The decoded video $168_1$ may be provided to one or more display devices for display to one or more human viewers. Decoder 1 $162_1$ may include one or more of entropy decoding 302, inverse transform and inverse quantization 218, in-loop filter 228, inter-frame prediction 236, and intra-frame prediction 238. Some of the functionalities are previously described and used in the encoder, such as encoder 102 of FIG. 2.

Entropy decoding 302 may decode the encoded bitstream 180 and output symbols that were coded in the encoded bitstream 180. The symbols may include quantized transform coefficients and syntax elements 278. Entropy decoding 302 may reconstruct the symbols from the encoded bitstream 180. Inverse transform and inverse quantization 218 may receive quantized transform coefficients and syntax elements 278 and perform operations which are performed in the encoder. Inverse transform and inverse quantization 218 may output reconstructed predicted residues 224. Summer 222 may receive reconstructed predicted residues 224 and predicted samples 212 and generate reconstructed predicted samples 226. Depending on the prediction modes signaled in the encoded bitstream 180 (e.g., as syntax elements in quantized transform coefficients and syntax elements 278), intra-frame prediction 238 or inter-frame prediction 236 may be applied to generate predicted samples 212. In-loop filter 228 may receive reconstructed predicted samples and output decoded video $168_1$.

*Entropy coding and probability estimations in entropy coding*

One part of video compression is entropy coding, which writes data into a compressed, encoded bitstream in a manner that reduces the data size of the bitstream. Entropy coding is a technique that compresses data by using the probability of each symbol to assign symbols to variable-length codes. The more probable symbols can be assigned shorter codes, while the less probable ones can be assigned longer codes. This way, the average code length is reduced, and the data size is reduced or minimized. Examples of entropy coding include, e.g., Huffman coding, arithmetic coding, QM-coder (e.g., arithmetic coding used in Joint Photographic Experts Group (JPEG) standards), CABAC, multi-CABAC, Daala entropy coder, entropy coding implemented in AV1, end-to-end variational autoencoder, etc. Mapping information of symbols to codes may be passed to the decoder to enable the decoder to decode the bitstream (e.g., to convert codes back into symbols). Different entropy coding techniques have various pros and cons.

Entropy coding is a part of an image or video codec. Arithmetic coding can provide an almost optimal compression ratio in terms of the Shannon limit. The encoding process may include division of a certain interval in proportion to the current probabilities of the alphabet symbols. The interval can be subdivided into subintervals according to the current cumulative probabilities of the symbols. The result of encoding of sequence of symbols may include a sequence of intervals. Any point from the last interval can unambiguously decode the sequence. The left or right end of the interval can be chosen. However, the probability of a next symbol (in many cases) is unknown in advance, thus an adaptive estimator for such probabilities can be implemented to update probability estimates on the fly. Updates may use statistics of already encoded symbols, and updated probability estimates can be determined on the fly based on the statistics. In addition, the probability distribution may change during the encoding process. Building highly accurate probability estimates with adaptability is one way to improve entropy compression algorithms.

A video can include a sequence of shots taken at different, but close moments. Therefore, the data to be encoded can have strong spatial and temporal correlation. Spatial and temporal correlation can allow high precision estimation of the probability of encoded symbols. In some video codecs, compressed bitstream may include a huge amount of different data. In some cases, the data may have a mixture of data from various sources, each source may have a different distribution of the probability for the appearance of a particular symbol. Encoding can depend on the context of the already encoded symbols. In other words, the probability of some symbol appearance can be represented as a conditional probability, depending on the context. Input video or image data can be divided among context models during encoding. Context models may include groups of syntax elements with similar statistical characteristics within the group. A context model has a corresponding probability distribution of a group of symbols, an alphabet, or a group of syntax elements. The probabilities of the probability distribution can be estimated within each context model independently or differently. However, even inside a particular context model, the probability distribution of symbols is not always constant. The probability distribution of symbols can depend on factors such as, e.g., quantization parameter, type of slice, type of content like objects, background, texture, etc. In some cases, probability estimation can benefit from having a fast probability adaptation mechanism.

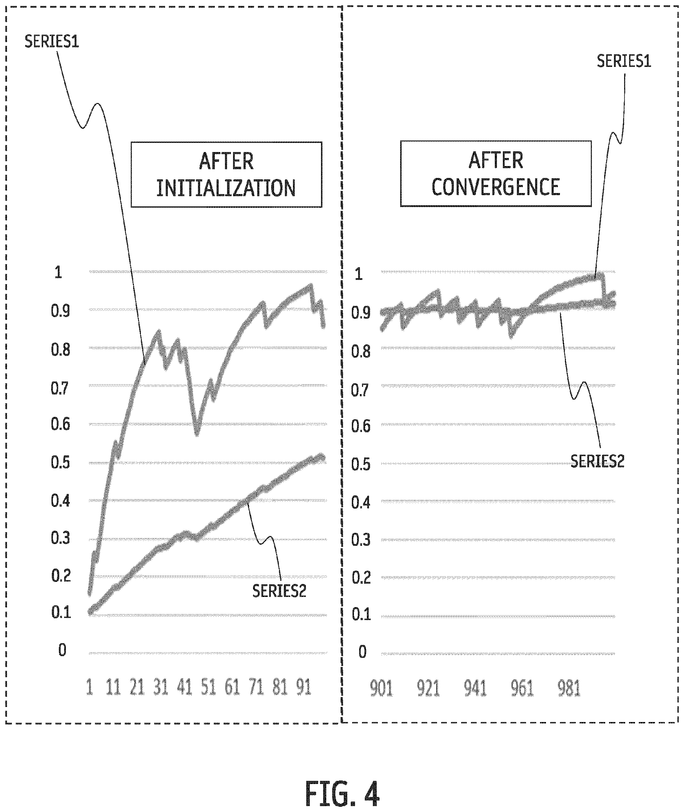

One technique used to adapt probability estimates to such variation is exponential smoothing. The formula of exponential smoothing can have a parameter $\alpha$. This parameter $\alpha$ may be responsible for the sensitivity of the model. The model with big value for parameter $\alpha$ can quickly react to probability changes and can quickly converge to optimal value. However, if the probability is constant (e.g., not changing very much), the variance of probability estimation is proportional to parameter $\alpha$. Thus, such smoothing with such quick adaptation to big probability shifts can suffer from high variance (e.g., lower precision) across optimal probability on stationary regions of the probability. Having a big value for parameter $\alpha$ can lead to suboptimal coding. In other words, for stationary regions, it can be better to use estimates obtained from exponential smoothing with small value for parameter $\alpha$. Some of these characteristics are illustrated in FIG. 4. Series1 may have $\alpha$ = 1/16. Series2 may have $\alpha$ = 1/128. Series1 with a bigger value for parameter $\alpha$ may converge more quickly, but Series1 may have high variation at the optimal value. Series2 with a smaller value for parameter $\alpha$ may converge more slowly, but Series2 may have a low variation at the optimal value.

The H.264 ("ITU-T H.264 (V13) (06/2019)", approved 2019-06-13) and H.265 ("ITU-T H.265 (V9) (09/2023)", approved 2023-09-13) codecs may use CABAC. CABAC may have three stages: binarization, context modeling, and arithmetic coding. Binarization may convert non-binary symbols, such as motion predictors or transform coefficients, into binary codes (e.g., a sequence of binary bits). Context modeling selects and updates the probability models for each bit based on the local context. Arithmetic coding encodes the bits using a multiplication-free range division and a look-up table. CABAC can exploit the inter-symbol redundancy and adapt to the characteristics of the video data. CABAC may be a binary arithmetic coder with adaptive probability update inside (each) context model. CABAC operates on two symbol values only, a binary "one" and a binary "zero", hence "binary arithmetic coding" in the name. A context model may have information on which symbol, e.g., a "zero" or "one", is a current most probable symbol (MPS) or least probable symbol (LPS) and information about the probability of LPS. This update can be based on a look-up table (LUT). This LUT may include an approximation for an exponential smoothing technique. An exemplary exponential smoothing technique can be expressed in a recursive form as:

$$p(t + 1) = \alpha x(t) + (1 - \alpha)p(t) \textbf{ (eq. 1)}$$

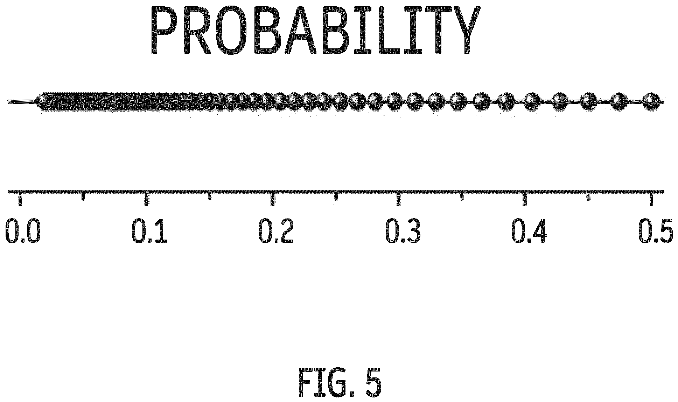

$x(t)$ is equal to "one" if the current symbol is LPS, and "zero" if not. $p(t)$ represents the current probability, and $p(t + 1)$ represents the updated probability. The probability in CABAC can be represented by one of 63 discrete values set on an exponential mesh as illustrated in FIG. 5. The exponential mesh may be represented as:

$$p_n = 0.5(1 - \alpha)^n \textbf{ (eq. 2)}$$

The value $1/\alpha$ can be called "memory size" or "window size". The value may indicate how many previously encoded symbols have a have a significant influence on current probability estimation (for CABAC, N may be 19.69).

The Versatile Video Coding (VVC) specification uses entropy coding that may be similar to CABAC implemented in High Efficiency Video Coding (HEVC) and may implement probability estimation differently. In the VVC specification, there may be about four hundred context models which may correspond to 65 different types of data. VVC, also known as "ITU-T H.266 (V3) (09/2023)", was approved 2023-09-29.

Some video codecs support binary arithmetic coding. In contrast, AV1 uses multi-symbol arithmetic coding. Multi-symbol arithmetic coding deals with multiple symbols (not necessarily binary values) at a time. Multi-symbol arithmetic coding can assign one or more bits for symbols belonging to an alphabet of size N. For example, multi-symbol arithmetic coding can perform entropy coding directly on symbols (e.g., quantized transform coefficients, syntax elements, etc.) without binarization. For example, a syntax element in AV1 may belong to an alphabet of N elements. N is greater than or equal to 2. N can be greater than or equal to 3. An alphabet of N elements may include N different syntax elements, or N different symbol values (or N possible symbols). In AV1, the size of the alphabet N may not exceed 16. AV1 may have multiple alphabets. For such setup, a context model corresponding to an alphabet having N elements may include N probabilities and one counter of updates. For probability estimation in multi-symbol arithmetic coding, the exponential smoothing formula can be applied. To simplify implementation and avoid multiplications, a set of possible $\alpha$'s can be limited to negative integer powers of two. The probability update can be expressed as follows (e.g., involving bit-shifts):

$$P(t) = x(t)(32768 >> \beta) + P(t) - (P(t) >> \beta) \textbf{ (eq. 3)}$$

$\beta$ is a bit-shift parameter which can perform division by integer powers of two, e.g., effectively multiplying by $\alpha$. In some cases, $\alpha = 2^{-\beta}$ or $\beta = - \log_2 \alpha$.

*Exemplary multi-symbol arithmetic coding implementation, including updating cumulative probability estimates*

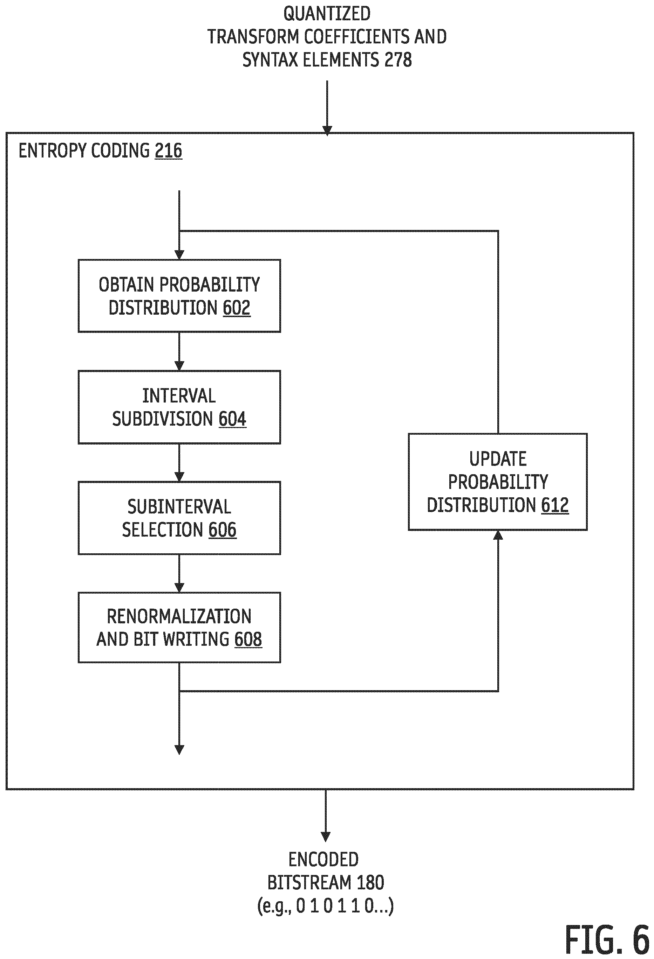

AV1 may implement multi-symbol entropy coding. FIG. 6 illustrates an exemplary multi-symbol arithmetic coding technique implemented in an entropy coding process, according to some embodiments of the disclosure. The multi-symbol arithmetic coding technique may be implemented in entropy coding 216 of FIG. 2. Entropy coding 216 may receive quantized transform coefficients and syntax elements 278 (e.g., referred to herein as a sequence of symbols) and perform entropy coding. Entropy coding 216 may generate and output encoded bitstream 180. Entropy coding 216 may encode the sequence of symbols as a compressed bitstream, e.g., encoded bitstream 180.

Multi-symbol entropy encoding, as implemented in entropy coding 216, may encode symbols from a priori known alphabet of size N using arithmetic coding. The size of the alphabet, N, may vary across context models. For AV1, the size of the alphabet, N, may not be greater than 16.

Entropy coding 216 may recursively divide an interval into subintervals. The process may cause one or more bits to be written to the encoded bitstream 180. In some embodiments, the arithmetic coding process may manipulate variables: *Low* and *Range,* which may define the interval being subdivided according to the probability distribution. In some embodiments, the interval and subintervals may be defined by other variables. *Low* may represent the first or low value of the interval. *Low* may start at 0. *Range* may be the width of the interval. *Range* may start or begin at 1. The interval may be subdivided into N subintervals according to the probability distribution. The widths of the N subintervals correspond to the probabilities for the N symbols of the alphabet. The subinterval that corresponds to the current symbol to be encoded is selected. Once the subinterval is selected, the variables: *Low* and *Range,* are updated accordingly to represent the selected subinterval. *Low* may be updated to reflect the first value or low value of the subinterval: $Low_t = Low_{t-1} + Range_{t-1} \times CDF[i = value]$, where $CDF[i = value]$ may correspond to the cumulative probability estimate corresponding to the current symbol (e.g., $P(i < value)$). *Range* may be updated to reflect the width of the subinterval: $Range_t = Range_{t-1} \times P[i = value]$, where $P[i = value]$ may correspond to the probability estimate corresponding to the current symbol (e.g., $P(i = value)$). The updated *Range* may be rescaled, 0 or more times, to make sure the condition for *Range* is met, e.g., $0.5 \leq Range \leq 1$. When *Range* does not meet the condition (e.g., $0.5 \leq Range \leq 1$), *Range* may be renormalized one or more times to meet the condition. Renormalization may multiply both *Low* and *Range* by 2 (e.g., perform a left-bit-shift by 1), so that both *Low* and *Range* values are doubled and increased. If *Low* goes above 1 (e.g., $Low > 1$) after renormalization, a bit = "1" is generated and written to the encoded bitstream. Also, *Low* may then be subtracted by 1. Otherwise (e.g., if *Low* is below 1, or $Low < 1$), a bit = "0" is generated and written to the encoded bitstream. Renormalization continues until *Range* meets the condition (e.g., $0.5 \leq Range \leq 1$). The recursive process of interval subdivision is illustrated in FIG. 6.

In 602, entropy coding 216 may obtain a obtaining a probability distribution, e.g., corresponding to an alphabet. The alphabet may include binary symbols and/or non-binary symbols. To facilitate interval subdivision, the probability distribution may be a cumulative probability distribution. The cumulative probability distribution may be defined by a CDF. Estimating the cumulative probability distribution involves estimating points of the CDF that correspond to different symbols of the alphabet.

The probability distribution may include a first cumulative probability estimate (e.g., a first point of the probability distribution or CDF) corresponding to a first symbol/element in the alphabet, and a second cumulative probability estimate (e.g., a second point of the probability distribution or CDF) corresponding to a second symbol in the alphabet. The probability distribution may include further cumulative probability estimates (e.g., further points of the probability distribution or CDF) corresponding to further symbols in the alphabet. The cumulative probability estimates may be stored as 15-bit values (e.g., with high precision) in AV1. Cumulative probability estimates can facilitate division of the interval defined by *Range.* For an alphabet of N elements, the probability distribution may include N points, e.g., $cdf[i]$, where $i = 0, ..., N - 1$, or N cumulative probability estimates. Cumulative probability estimates of the probability distribution can be stored in an array, $cdf[i]$ at indices $i$ going from 0 to $N - 1$. N may be at least two. N may be at least three.

In 604, entropy coding 216 may subdivide an interval according to (at least) the first cumulative probability estimate, and the second cumulative probability estimate. Entropy coding 216 may subdivide the interval into N subintervals, each interval corresponding to each one of the N symbols in the alphabet. The widths of the subintervals may correspond to the probability estimates of the N symbols. The interval may be subdivided using points of the CDF, or $cdf[i]$, where $i = 0, ..., N - 1$, which can be used to determine the boundaries between subintervals within the interval defined by *Range*. $Range \times CDF[i]$ can be used as offsets or offset values from the first value or low value (*Low*) of the interval being subdivided, and the offsets or offset values are the values that mark the boundaries between the subintervals. The interval may be subdivided into at least two subintervals according to points of the probability distribution. The interval may be subdivided into at least three subintervals according to the probability distribution.

In 606, entropy coding 216 may select a subinterval of the subintervals obtained in 604. The subinterval may be selected based on a current symbol, *value,* that appears in the sequence of symbols. Entropy coding 216 may select a subinterval in the interval corresponding to the current symbol in the sequence of symbols.

In 608, entropy coding 216 may perform renormalization and bit writing. Entropy coding 216 may write one or more bits according to the subinterval to the compressed bitstream.

In update probability distribution 612, entropy coding 216 may update the probability distribution based on the observation of the current symbol. Entropy coding 216 may adaptively update points of the probability distribution as symbols are being encoded. Entropy coding 216 may update the cumulative probability estimates of the probability distribution, e.g., the first cumulative probability estimate and the second cumulative probability estimate.

Once the probability distribution is updated, the recursive process may continue again at 602 by obtaining an updated probability distribution having updated cumulative probability estimates, e.g., an updated first cumulative probability estimate and an updated second cumulative probability estimate. The subinterval selected in 606 (or a renormalized version thereof) may be subdivided according to the updated probability distribution.

Instead of calculating probabilities for each symbol $P(i = value)$ when updating the probability distribution in update probability distribution 612, multi-symbol arithmetic coding may calculate cumulative probability estimates, which is a probability of $i < value$, e.g., $P(i < value)$. Calculation of cumulative probability estimates helps to divide an interval into subintervals proportionally to the probabilities of the different symbols of the alphabet.

Exemplary cumulative probability estimate updates/calculations in AV1 are illustrated in TABLE 1. For each cumulative probability estimate of the CDF, the current symbol is compared against the index $i$, and a corresponding update to the cumulative probability estimate is performed or a corresponding update formula is applied to update the cumulative probability estimate.

**TABLE 1. CDF updates in AV1**

| $i < value$ | $i \geq value$ |
|---|---|
| cdfnew[$i$] = cdf[$i$] + | cdfnew[$i$] = cdf[$i$] - |
| ((32768 - cdf[$i$]) >> rate) | (cdf[$i$] >> rate) |

Index $i$ can run from 0 to N-1 where N is the alphabet size. Inequality $cdf[i] \geq cdf[i+1]$ may be always valid. In some implementations, for ease of implementation, $cdf[i]$ may correspond to $1 - P(i < value)$. $cdf[N-1]$ may be equal to zero if $rate$ does not depend on index $i$. In some cases, $rate$ (which is related to $\alpha$ in exponential smoothing) can depend on a number of updates. Together with N cumulative probability estimates, a number of updates or a counter may be stored as a last element of the array, e.g., $cdf[N]$:

$$cdf[N](t + 1) = cdf[N](t) + (cdf[N](t) < 32) \text{ (eq. 4)}$$

$t$ may represent time. Counter $cdf[N]$ may be updated with +1 when a next symbol comes in, until value of the counter reaches 32 or some other suitable predetermined value.

A syntax element in AV1 can belong to the alphabet of N elements. The size of the alphabet N may not exceed 16 in AV1. Each context can include a probability distribution having N cumulative probability estimates and one counter of updates. For probability estimation, the exponential smoothing technique can be applied. It can be expressed in a recursive form as:

$$p[i](t + 1) = \alpha x[i](t) + (1 - \alpha)p[i](t) \text{ (eq. 5)}$$

$x(t)$ may be an indicator function (e.g., $x(t)$ equals to zero or one). For events where $value < i$, where $value$ is a newly coming symbol for encoding from a current alphabet, and $i$ runs through all possible alphabet values. There can be a set of $x(t)$ depending on $i$ for each probability distribution, e.g., for each context model. An entropy coder may include a plurality of probability distributions corresponding to different context models.

In equation 5, $t$ may be time, and when a new symbol is coming to compressor, the new symbol may trigger an update of all probabilities $p[i](t)$, where $i$ may be an index of the symbols of alphabet. Together the set of $\{p[i](t)\}$ for all $i$ can form CDF(t), which can describe the cumulative probability distribution. $cdf[i]$ at different indices, $i = 0, ..., N - 1$, may correspond to cumulative probability estimates of N alphabet symbols, or N points of the cumulative probability distribution.

To simplify implementation and avoid multiplications, a set of possible $\alpha$'s can be limited to negative integer powers of two (equation 3 is reproduced below):

$$P(t + 1) = x(t)(32768 >> \beta) + P(t) - (P(t) >> \beta) \text{ (eq. 3)}$$

$P(t)$ may be a fixed-point representation of probability $P(t)$ using 15 bits. The parameter $\beta$ can have a similar but opposite meaning as parameter $\alpha$ in the context of exponential smoothing. Parameter $\alpha$ may be related to parameter $\beta$ as

follows.

$$\alpha = 2^{-\beta} \text{ (eq. 6)}$$

$\beta$ may depend on the number of updates (e.g., counter) and alphabet size. Small $\beta$ may correspond to fast adaptation to optimal probabilities. After convergence to optimal value, probability estimation with a small $\beta$ may have a small variance of prediction. That is why starting with relatively small values, $\beta$ may gradually increase with a number of updates or higher counter value.

As described in Table 1, suppose the current symbol to be encoded is represented by *value,* then update of cumulative probability estimates, *cdf*[*i*] with indices *i* = 0, ..., *N* - 1 may be implemented as follows:

$$\text{if } i < value$$

$$cdfnew[i] = cdf[i] + ((32768 - cdf[i]) >> \beta)$$

$$\text{Else or if } i \geq value$$

$$cdfnew[i] = cdf[i] - (cdf[i] >> \beta)$$

*cdf*[*N* - 1] may be (always) zero, so (only) N-1 updates of CDF (e.g., N-1 cumulative probability estimate updates) and one update for the counter can be implemented. $\beta$ may be a bit-shift parameter.

The increase of alphabet size can bring additional gains in terms of bit saving. Estimation complexity can grow with a larger alphabet. The reason is the number of calculations in the multi-symbol case can be significantly higher, but these calculations could be parallelized. In a case with an alphabet size N=16, to encode one symbol, 15 cumulative probability estimates, each having a 15-bit representation, and one counter may be updated and maintained.

**TABLE 2: Comparing a number of updates and memory for a case where N=16 with different codecs**

|  | AV1 | HEVC | VVC |
|---|---|---|---|
| Number of updates | 15+1 | 4 | 8 |
| Memory | 230 bits | 28 bits | 12 bytes=96bits |

The increase of alphabet size may lead to a decrease in probability for each symbol. Length of interval subdivision can be close to a range of *p*[*i*]. If *p*[*i*] is close to zero, the number of bits for range representation may be increased to have enough bits to represent small probabilities. *Range* in multi-symbol arithmetic coding may be the size (width or length) of the interval that represents the current encoded symbols. The interval may be divided into subintervals according to the probabilities of the symbols. A subinterval may be further divided when a new symbol is encoded. The smaller the range, the more bits may be used to encode the range.

**TABLE 3: Comparing range with different codecs**

|  | AV1 | HEVC | VVC |
|---|---|---|---|
| *Range* | 32768-65535 | 256-511 |  |

Another problem is the possibility that after division, *Range* becomes zero. It may mean that renormalization (e.g., interval length or *Range* changes, performed with multiplication) is not possible. To prevent *Range* from becoming zero, AV1 can use the following trick which guarantee that *Range* is always greater than 0 by guaranteeing *Range* to always be greater than or equal to 4:

```
u = ((range>>8)*(fl>>6)>>1 + 4*(N-(value-1));
```

```
v = ((range>>8)*(fh>>6)>>1)) + 4*(N-(value+0));
```

$$range = u-v$$

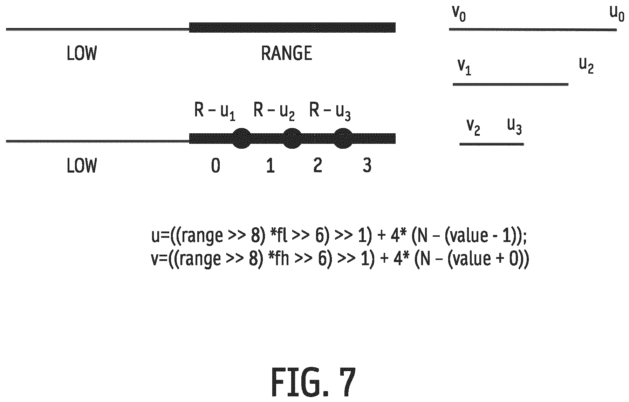

fl and fh may be cumulative probability estimates. fl and fh may correspond to values that mark the maximum and minimum values/boundaries of the subinterval corresponding to the current symbol, value. An example of interval subdivision for AV1 for dictionary size N=4 is illustrated in FIG. 7.

*Updating a cumulative probability estimate using two or more adaptation parameters*

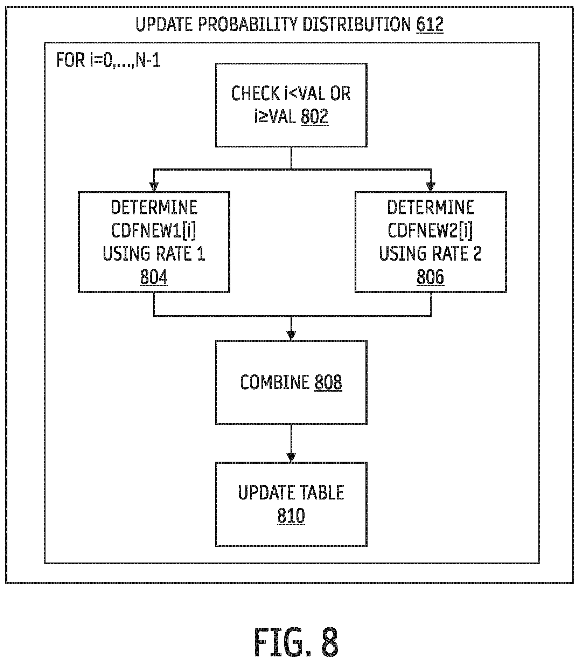

FIG. 8 illustrates updating a probability distribution for adaptive multi-symbol arithmetic coding, according to some embodiments of the disclosure. An exemplary implementation of update probability distribution 612 is depicted.

Two or more cumulative probability estimates for multi-symbol arithmetic coding, as applied to updating of a probability distribution, can determined using the formulas according to TABLE 4:

**TABLE 4. Updates to a cumulative probability estimate using a weighted sum of probability estimates**

| *i < value* | *i ≥ value* |
|---|---|
| *cdfnew*1[*i*] = *cdf*[*i*] + ((32768 - *cdf*[*i*]) >> *rate*1) <br> *cdfnew*2[*i*] = *cdf*[*i*] + ((32768 - *cdf*[*i*]) >> *rate*2) <br> *cdfnewmix*[*i*] = (*cdfnew*1[*i*] + *cdfnew*2[*i*]) >> 1 | *cdfnew*1[*i*] = *cdf*[*i*] - (*cdf*[*i*] >> *rate*1) <br> *cdfnew*2[*i*] = *cdf*[*i*] - (*cdf*[*i*] >> *rate*2) <br> *cdfnewmix*[*i*] = (*cdfnew*1[*i*] + *cdfnew*2[*i*]) >> 1 |

This approach illustrated in TABLE 4 may involve two or more rates (e.g., *rate*1 and *rate*2) for each cumulative probability estimate update. Updating the probability distribution for an alphabet may include two or more adaptive cumulative probability estimate updates for each point of the CDF corresponding to each element/symbol in the alphabet. The approach may yield two or more adaptive cumulative probability estimates (e.g., *cdfnew*1[*i*] and *cdfnew*2[*i*]) for each point of the CDF or each cumulative probability estimate. The approach may allow a final, mixed, combined cumulative probability estimate (e.g., *cdfnewmix*[*i*]) having a mixture or combination of the two or more adaptive cumulative probability estimates (e.g., *cdfnew*1[*i*] and *cdfnew*2[*i*]), to stay close to the global mean value and may allow fast probability estimation adjustment reacting to variations in incoming symbols probability. If encoded data has strong autocorrelation this approach can be especially effective.

Phrased differently, the final, mixed, combined cumulative probability estimate (e.g., *cdfnewmix*[*i*]) can be determined using two or more cumulative probability estimators. The two or more cumulative probability estimators may be combined using appropriate logic that may optimize the accuracy of the final, mixed, combined cumulative probability estimate. For brevity, some examples described herein combine two cumulative probability estimators, or two adaptive cumulative probability estimates determined using two rates. It is envisioned by the disclosure that additional estimators or adaptive cumulative probability estimates determined using additional rates can be used.

The probability distribution update process in update probability distribution 612 may be performed for *cdf*[*i*] at each/individual indices, e.g., *i* = 0, ..., *N* - 1. In other words, to update the probability estimate, N cumulative probability estimates or N points of the probability distribution may be determined. For each cumulative probability estimate or points, the update may be based on a combined/mixed cumulative probability estimate update that is computed based on at least two different adaptation parameters. For example, a first cumulative probability estimate of the probability distribution may be updated using a first combined/mixed cumulative probability estimate (e.g., *cdfnewmix[i])* computed based on at least two different adaptation parameters. A second cumulative probability estimate of the probability distribution may be updated using a second combined/mixed cumulative probability estimate (e.g., *cdfnewmix[i])* computed based on the at least two different adaptation parameters. Different adaptation parameters may determine a rate or speed at which estimates are updated when symbols are observed. Different adaptation parameters may cause fast adaptation or slow adaptation.

As depicted, update probability distribution 612 may perform 802, 804, 806, 808, and 810 to update individual cumulative probability estimates, *cdf*[*i*], corresponding to different indices *i* = 0, ..., *N* - 1 based on a current symbol *value*. The individual cumulative probability estimates may be updated by determining corresponding combined/mixed cumulative probability estimates, which are each obtained from multiple adaptive cumulative probability estimates computed using different adaptation parameters or rates. Update probability distribution 612 may perform 802, 804, 806, 808, and 810 to update N cumulative probability estimates of a cumulative probability distribution function. The N points or N cumulative probability estimates of the probability distribution function along with a counter may be stored in a table.

In 802, the current symbol *value* may be checked whether *i < value* is true or *i ≥ value* is true. A corresponding cumulative probability estimate update formula (e.g., as illustrated in TABLE 4) may be determined based on the current symbol value *value* relative to the CDF index *i*.

In 804, update probability distribution 612 may determine a first adaptive cumulative probability estimate (e.g., *cdfnew*1[*i*]) using a first rate, e.g., ratel. The first adaptive cumulative probability estimate may be based on a first adaptation parameter (e.g., rate1) and a first memory of the first adaptive cumulative probability estimate (e.g., *cdf*[*i*]). If *i* < *value* is true, the first adaptive cumulative probability estimate may be updated according to the following formula: *cdfnew*1[*i*] = *cdf*[*i*] + ((32768 - *cdf*[*i*]) >> *rate*1). If *i* ≥ *value* is true, the first adaptive cumulative probability estimate may be updated according to the following formula: *cdfnew*1[*i*] = *cdf*[*i*] - (*cdf*[*i*] >> *rate*1).

In 806, update probability distribution 612 may determine a second adaptive cumulative probability estimate (e.g., *cdfnew*2[*i*]) using a second rate, e.g., rate2. The second adaptive cumulative probability estimate may be based on a second adaptation parameter (e.g., rate2) and a second memory of the second adaptive cumulative probability estimate (e.g., *cdf*[*i*]). If *i* < *value* is true, the second adaptive cumulative probability estimate may be updated according to the following formula: *cdfnew*2[*i*] = *cdf*[*i*] + ((32768 - *cdf*[*i*]) >> *rate*2). If *i* ≥ *value* is true, the second adaptive cumulative probability estimate may be updated according to the following formula: *cdfnew*2[*i*] = *cdf*[*i*] - (*cdf*[*i*] >> *rate*2).

In some cases, one or more additional adaptive cumulative probability estimates may be computed using one or more additional rates or adaptation parameters, e.g., following the example illustrated in 804 and 806.

In 808, the first adaptive cumulative probability estimate (e.g., *cdfnew*1[*i*]) of 804 and the second adaptive cumulative probability estimate (e.g., *cdfnew*2[*i*]) of 806 can be combined to form the first combined cumulative probability estimate (e.g., *cdfnewmix*[*i*]) of the cumulative probability distribution. The first combined cumulative probability estimate may be determined using the following formula: $cdfnewmix[i] = \omega_1 * cdfnew1[i] + \omega_2 * cdfnew2[i]$. $\omega_1$ and $\omega_2$ may be weights corresponding to *cdfnew*1[*i*] and *cdfnew*2[*i*] respectively in the weighted sum, *cdfnewmix*[*i*]. Weights corresponding to the adaptive cumulative probability estimates may sum to 1. In some implementations, exemplary values for a weight may include 0, 1, ½, ¼, etc. Such values can be used to facilitate binary arithmetic without multiplication with floats.

In some cases, the first adaptive cumulative probability estimate (e.g., *cdfnew*1[*i*]) of 804 and the second adaptive cumulative probability estimate (e.g., *cdfnew*2[*i*]) of 806 can be summed or combined in 808 to determine a sum. A bit-shift may be applied to the sum. For example, a one-right-bit-shift may be applied to divide the sum by 2. The first combined cumulative probability estimate may be determined as follows: *cdfnewmix*[*i*] = (*cdfnew*1[*i*] + *cdfnew*2[*i*]) >> 1. The calculation is equivalent to having the weights corresponding to the first adaptive cumulative probability estimate and the second adaptive cumulative probability estimate to be ½.

In some cases, determining the first combined cumulative probability estimate may be determined by computing a weighted sum of the first adaptive cumulative probability estimate (e.g., *cdfnew*1[*i*]) and the second adaptive cumulative probability estimate (e.g., *cdfnew*2[*i*]) to determine a weighted sum, e.g., a quantity that reflects $\omega_1 * cdfnew1[i] + \omega_2 * cdfnew2[i]$.

In some cases, determining the first combined cumulative probability estimate may include performing a linear combination of the adaptive cumulative probability estimates (e.g., the first adaptive cumulative probability estimate *cdfnew*1[*i*] and the second adaptive cumulative probability estimate *cdfnew*2[*i*]). In some cases, determining the first combined cumulative probability estimate may include performing a non-linear combination of the adaptive cumulative probability estimates (e.g., the first adaptive cumulative probability estimate *cdfnew*1[*i*] and the second adaptive cumulative probability estimate *cdfnew*2[*i*]). In some cases, determining the first combined cumulative probability estimate may include combining the adaptive cumulative probability estimates (e.g., the first adaptive cumulative probability estimate *cdfnew*1[*i*] and the second adaptive cumulative probability estimate *cdfnew*2[*i*]) according to a function of the adaptive cumulative probability estimates (e.g., *cdfnewmix*[*i*] = *f*(*cdfnew*1[*i*], *cdfnew*2[*i*]).

808 may be performed to determine a second combined cumulative probability estimate and additional combined cumulative probability estimates corresponding to other symbols in the alphabet, for other indices *i*.

In 810, a table or array having the cumulative probability estimates corresponding to different symbols in the alphabet may be updated using the first combined cumulative probability estimate. The table or array may be updated using additional combined cumulative probability estimates calculated using the processes illustrated in 802, 804, 806, and 808. The cumulative probability estimates for all symbols of the alphabet, *cdf*[*i*] where *i* = 0, ..., *N* - 1, may be updated in the table/array. The counter stored in the last element of the table/array, e.g., *cdf*[*N*], may be incremented by 1.

*Varying adaptation parameters*

In some embodiments, the rate (e.g., rate1 and rate2 as illustrated in TABLE 4) may change based on the number of updates made (e.g., according to the number of updates or the counter value for the table). In a coding scheme where a single rate is used:

$$rate = init + (cdf[N] > 15) + (cdf[N] > 31) + nsymbs2speed[N]$$

For example, *nsymbs*2*speed*1[*17*] = {0, 0, 1, 1, 2, 2, 2, 2, 2, 2, 2, 2, 2, 2, 2, 2, 2}, and *init* = 3. *rate* may depend on an initial value and the number of updates (e.g., the counter stored as the last element in the table or array, *cdf*[*N*]). *init* may be an initial value for *rate*. *nsymbs*2*speed*[*N*] may control a speed of convergence of *rate*. Suppose the dictionary size is 2.

*rate* can start from 3+1=4. After a number of updates reaching 16, *rate* can become 5. After the number of updates exceeds 32, *rate* may become 6. *rate* may not change until entropy reset. Initial entropy encoder probabilities (e.g., default values at the start) may be far from optimal, so the probability estimation algorithm may converge quickly to probabilities observed in the stream.

Fast adaptation can be provided by a small *rate* (e.g., big value for parameter $\alpha$). However, after convergence, it may be better to use a big *rate* (e.g., small value for parameter $\alpha$) to reduce variation.

To implement two or more estimates using two or more rates, e.g., *rate*1 and *rate*2) as illustrated in TABLE 4, the following formulas can be used for determining the rates:

$$rate1 = init1 + (cdf[N] > 15) + (cdf[N] > 31) + nsymbs2speed1[N]$$

$$rate2 = init2 + (cdf[N] > 15) + (cdf[N] > 31) + nsymbs2speed2[N]$$

*init*1 may be an initial value for *rate*1. *nsymbs2speed*1[*N*] may control a speed of convergence of *rate*1. *cdf*[*N*] may be the number of updates (e.g., the counter value) for the probability distribution. A value for *init*1 may be 0 or 1. *init*2 may be an initial value for *rate*2. *nsymbs2speed*2[*N*] may control a speed of convergence of *rate*2. A value for *init*2 may be 4 or 5. *nsymbs2speed*1[*N*] and *nsymbs2speed*2[*N*] can be the same or different. *init*1 and *init*2 can be the same for all context models. *init*1 and *init*2 can be different or unique for the context models, and the values can be conveyed in the encoded bitstream.

Besides changing rates (e.g., the adaptation parameters) based on the number of updates or the counter value of the table/array, the at least two different adaptation parameters used in determining first and second adaptive cumulative probability estimates for calculating a combined cumulative probability estimate can be specific to a context model corresponding to a set of symbols in an alphabet. In some cases, the manner in which the rates or adaptation parameters change based on the number of updates or the counter value may differ for different context models.

*Detecting a shift in probability and resetting the estimators*

If the probability of a symbol (or the probability distribution overall) suddenly changes, then first estimator of model (e.g., with big value for parameter $\alpha$) may quickly react to these changes, but the second estimator of model (e.g., with small value for parameter $\alpha$) may be close to the previous optimal value. The second estimator with slower adaptation may take a few more incoming symbols for the estimator to reach the new probability. The difference between the two estimations can dramatically increase, e.g., when an estimate is close to an optimal value. It is possible to utilize this difference as criteria and/or signal to change the one or more ones of the rate(s) or swap to use a (more optimal) one of the plurality of rates. For example, a shift or change in probability can be detected when the difference between the two estimations is sufficiently large. In response, one or more entropy coding parameters can be adjusted, e.g., reset, to quickly adapt and provide optimal compression. The difference between two probability estimations, e.g., as a measure of proximity to optimal probability or indicator that probability is shifting or changing, is illustrated in figures (FIGS.) 9-10.

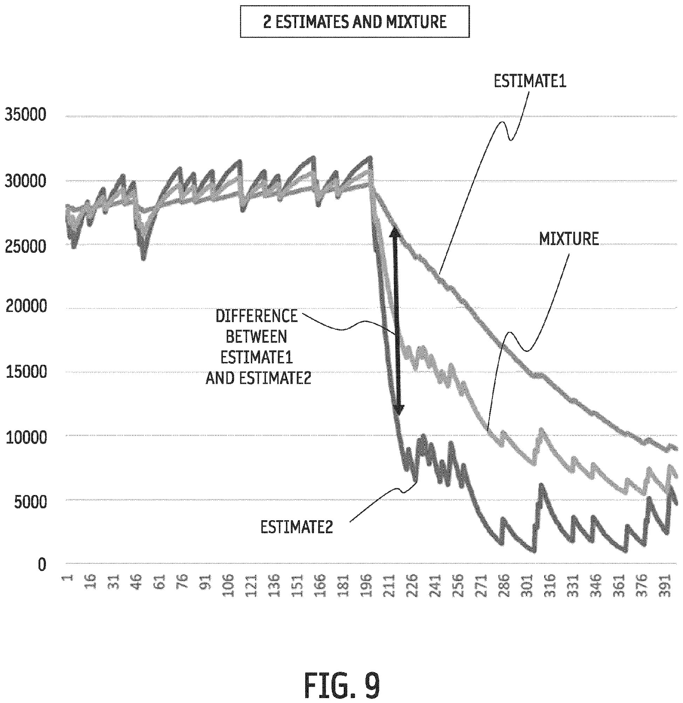

In FIG. 9, a first plot of a first adaptive cumulative probability estimate (ESTIMATE1, e.g., calculated in 804 of FIG. 8), a second adaptive cumulative probability estimate (ESTIMATE2, e.g., calculated in 806 of FIG. 8), and the mixture/mixed/combined estimate (MIXTURE, e.g., calculated in 808 of FIG. 8) based on the first adaptive cumulative probability estimate and the second adaptive cumulative probability estimate over many updates is depicted. The first adaptive cumulative probability estimate, the second adaptive cumulative probability estimate, and the combined estimate shown may correspond to a combined cumulative probability estimate of a symbol in the alphabet. The difference between ESTIMATE1 and ESTIMATE2 may be a measure of proximity to optimal probability.

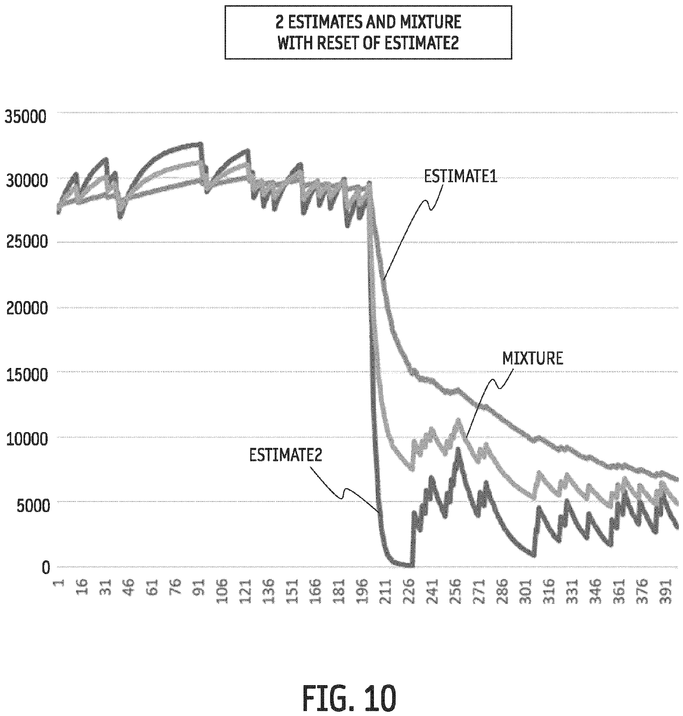

In FIG. 10, a second plot of a first adaptive cumulative probability estimate (ESTIMATE1, e.g., calculated in 804 of FIG. 8), a second adaptive cumulative probability estimate (ESTIMATE2, e.g., calculated in 806 of FIG. 8), and the mixture/mixed/combined estimate (MIXTURE, e.g., calculated in 808 of FIG. 8) based on the first adaptive cumulative probability estimate and the second adaptive cumulative probability estimate over many updates is depicted. The first adaptive cumulative probability estimate, the second adaptive cumulative probability estimate, and the combined estimate shown may correspond to a cumulative probability estimate of a symbol in the alphabet. When the difference between the first adaptive cumulative probability estimate and the second adaptive cumulative probability estimate exceeds a threshold, the counter of updates to the probability estimate, *cdf*[*N*], can be reset to zero. Resetting the counter may adjust the adaptation parameter used in determining ESTIMATE2. As a result, the combined estimate MIXTURE becomes closer to the optimal probability sooner, and the combined estimate MIXTURE may be more accurate and can lead to more optimal compression efficiency.

In some embodiments, the probability estimates and/or the adaptation parameters can be controlled or reset based on the difference between the two or more adaptive cumulative probability estimates. In other words, the adaptation behavior can be controlled or reset based on the difference between the two or more adaptive cumulative probability estimates. In some cases, adaptation behavior can change by resetting the probability distribution to reflect equal probability of all the symbols in the alphabet (e.g., probability of the symbol may be equal to 1/N), thereby erasing past memory of what has been observed in the incoming sequence of symbols. Resetting the probability estimates (e.g., cumulative probability estimates of symbols in the alphabet) may erase memory/history of past estimates, and/or restart adaptation for the probability distribution. In some cases, adaptation behavior can change by resetting a counter of the probability distribution (e.g., number of updates), which may impact the adaptation rates being used to calculate the adaptive cumulative probability estimates. In some cases, adaptation behavior can change by modifying the adaptation rates directly.

In some embodiments, the adaptation behavior can change according to the following algorithm:

$$\text{If} \left( \max_{0 \le i \le N-1} |cdfnew1[i] - cdfnew2[i]| > threshold \right),$$

Then: Reset adaptation.

*threshold* can be predetermined. *threshold* can be the same for all context models. *threshold* can be unique or different for different context models. *threshold* can be different for different symbols in the alphabet. *threshold* can depend on the history of previous cumulative probability estimates of the probability distribution (e.g., at time t-1, t-2, etc.).

Resetting may include one or more of the following:

- Set, e.g., *cdf[N],* the counter, to zero;
- Set, e.g., *cdfnew*1[*i*] and/or *cdfnew2[i]* to $\frac{N-i}{N}$ for *i* = 0, ..., N - 1;
- Set, e.g., ratel and/or rate2 to a value that corresponds to fast adaptation.

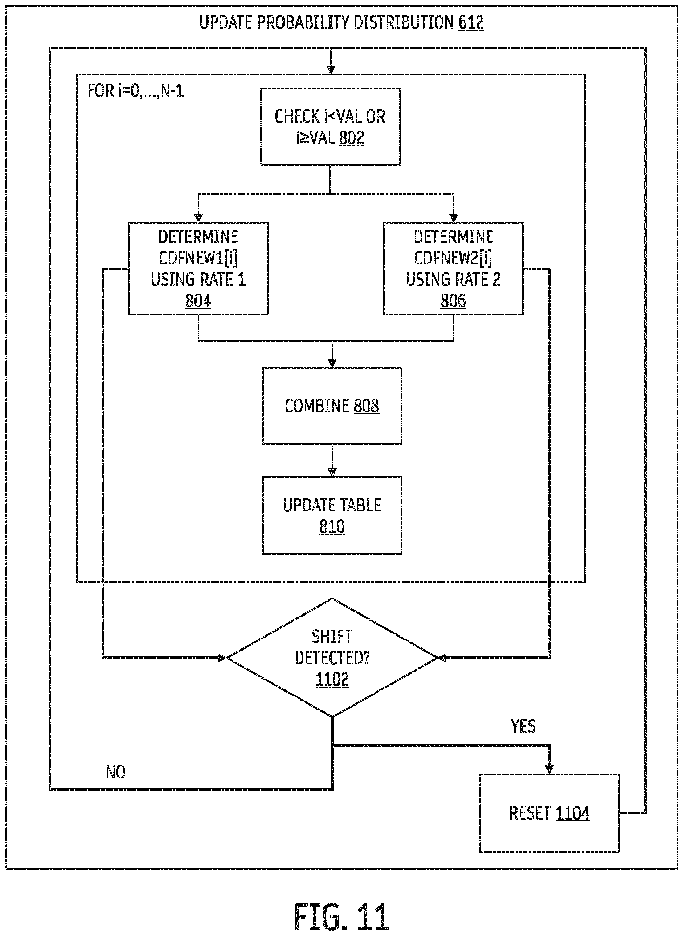

FIG. 11 illustrates updating probability distribution for adaptive multi-symbol arithmetic coding with resetting, according to some embodiments of the disclosure. An exemplary implementation of update probability distribution 612 is depicted.

804 may be implemented for each one of the N points of the CDF, or CDF indices *i* = 0, ..., *N* - 1 to determine first adaptive cumulative probability estimates corresponding to the symbols in the alphabet based on a first adaptation parameter. The first adaptive cumulative probability estimates may include *cdfnew*1[*i*] for individual CDF indices, e.g., *i* = 0, ..., *N* - 1, using the first adaptation parameter (e.g., rate1). 806 may be implemented for each one of the N points of the CDF, or CDF indices *i* = 0, ..., *N* - 1 to determine second adaptive cumulative probability estimates corresponding to the symbols in the alphabet based on a second adaptation parameter. The second adaptive cumulative probability estimates may include *cdfnew*2[*i*] for individual CDF indices, e.g., *i* = 0, ..., *N* - 1, using the second adaptation parameter (e.g., rate2).

In 1102, a shift in the (true/optimal) cumulative probability estimate may be detected. The shift may be detected using the first adaptive cumulative probability estimates and the second adaptive cumulative probability estimates, since the difference between the two estimates may be a measure of proximity to the optimal probability and/or an indicator that the probability is changing. In some embodiments, a difference, e.g., absolute difference, can be determined on a per-symbol basis, e.g., for each CDF indices *i* = 0, ..., *N* - 1. |*cdfnew*1[*i*] - *cdfnew*2[*i*]| can be computed for each CDF indices, e.g., *i* = 0, ..., *N* - 1. A maximum of the per-symbol absolute differences between the first adaptive cumulative probability estimates and the second adaptive cumulative probability estimates can be determined. A shift may be detected if the maximum crosses/exceeds a threshold. In some cases, if a certain number of the per-symbol absolute differences (e.g., one or more absolute differences) crosses/exceeds the threshold, a shift may be detected. For instance, if at least half of the per-symbol absolute differences crosses/exceeds the threshold, a shift may be detected. In another instance, if at least two or more of the per-symbol absolute differences cross/exceed the threshold, a shift may be detected. Other metric(s) can be used to detect a shift in the cumulative probability estimate, or the probability distribution as a whole.

In 1104, a reset operation may be performed to change the adaptive behavior in response to detecting a shift in the cumulative probability estimate. In some cases, the reset operation modifies how quickly the combined cumulative probability estimate would start to reflect the (true/optimal) cumulative probability estimate. In some cases, the reset operation resets/clears the memory used in updating adaptive cumulative probability estimates so that past memory is forgotten, and the adaptive cumulative probability estimates (more quickly) adapts and/or converges to the (true/optimal) cumulative probability estimate.

In some cases, in response to determining the maximum exceeds the threshold, the number of updates or the counter of the probability distribution, *cdf[N]*, may be reset in 1104, e.g., reset to a lower value, or reset to zero. In some cases, a number of updates or the counter, *cdf[N]* can be reset in 1104 in response to on a shift being detected in 1102. The counter *cdf[N]* can be reset to zero, e.g., Set, e.g., *cdf[N]*, the counter, to zero. When the counter *cdf[N]* is reset, e.g., reset to zero or to a lower value, the rate or adaptation parameter may change, since the rate or adaptation parameter can be dependent on the counter *cdf*[*N*]. Therefore, resetting the number of updates or the counter *cdf*[*N*] may impact adaptation behavior.

In some cases, adaptation can be reset in 1104 by making the probabilities of all N symbols of the alphabet to be equal to each other, e.g., 1/N, in response to on a shift being detected in 1102. Such reset can have the effect that memory of observed symbols is erased. Adaptation can be reset by setting the adaptive cumulative probability estimates as if the probabilities of all N symbols of the alphabet are equal to each other, e.g., Set, e.g., *cdfnew*1[*i*] and/or *cdfnew*2[*i*] to $\frac{N-i}{N}$ for *i* = 0, ..., *N* - 1.

In some cases, adaptation can be reset in 1104 by reducing the adaptation parameter (e.g., ratel and/or rate2) to a value that corresponds to fast adaptation. Adaptation can be partially reset by setting the adaptation parameter to ensure that fewer past estimates impact the estimator, and the estimator quickly adapts to the shift in probability.

After the reset operation in 1104, update probability distribution 612 may continue to update the probability distribution based on incoming symbols, which may include cumulative probability estimates whose adaptation behavior has been adjusted or reset due to the shift in probabilities being detected.

If a shift is not detected, update probability distribution 612 may continue to update probability distribution based on previously determined adaptive cumulative probability estimates.

*Other ways to detect a* *change or shift in the cumulative probability estimate*

Referring back to 1102 of FIG. 11, one mechanism for detecting a change or shift in the (true/optimal) probability distribution is to measure the difference, distance, and/or discrepancy between the first adaptive cumulative probability estimates and the second adaptive cumulative probability estimates and determine if the difference, distance, or discrepancy exceeds a threshold or meet a certain criterion. Phrased differently, a change or a shift in the probability distribution may be detected when the first adaptive cumulative probability estimates and the second adaptive cumulative probability estimates represent different probability distributions or are far apart from each other. When the first adaptive cumulative probability estimates and the second adaptive cumulative probability estimates represent different probability distributions, it is possible that the first adaptive cumulative probability estimates or the second adaptive cumulative probability estimates no longer represent the actual probability distribution.

Specifically, a maximum of the per-symbol absolute differences being compared against a threshold can be used as a metric in 1102 to determine how far apart the first adaptive cumulative probability estimates and the second adaptive cumulative probability estimates are. This implementation can represent an exemplary implementation of the Kolmogorov-Smirnov statistic or test (or the Kolmogorov or Uniform metric). It is envisioned by the disclosure that other types of tests, or probability metrics, that can measure distance or divergence of two random processes or two cumulative probability distributions (e.g., the first adaptive cumulative probability estimates and the second adaptive cumulative probability estimates) can be used as a metric in 1102. One example is to determine an area closed between graphs of the first adaptive cumulative probability estimates and the second adaptive cumulative probability estimates, and determine whether the area is close to zero. Another example is to determine a Lévy distance between the first adaptive cumulative probability estimates and the second adaptive cumulative probability estimates, and determine whether the Lévy distance exceeds a threshold.

*Varying weights to change adaptation behavior*

When combining the adaptive cumulative probability estimates (determined using different adaptation parameters) together using the weighted summing technique, the weights can determine a particular adaptive cumulative probability estimate's contribution to the weighted sum. The weighted sum of two adaptive cumulative probability estimates can be represented as: $\omega_1 * cdfnew1[i] + \omega_2 * cdfnew2[i]$. In some cases, the first adaptive cumulative probability estimate (e.g., *cdfnew*1[*i*]) and the second adaptive cumulative probability estimate (e.g., *cdfnew*2[*i*]) can be given different weights, e.g., $\omega_1 \neq \omega_1$. For example, $\omega_1 = 0$ and $\omega_2 = 1$. Or, $\omega_1 = 1$ and $\omega_2 = 0$. When a weight equals 0, the contribution of the corresponding adaptive cumulative probability estimate is effectively removed from the final cumulative probability estimate. Modifying the sets of weights used thus can change the contributions of the adaptive cumulative probability estimates to the final cumulative probability estimate. Changing the contributions can change the overall adaptation behavior of probability estimation, by making an adaptive cumulative probability estimate contribute more or less to the final cumulative probability estimate. For example, the weight corresponding to the particular adaptive cumulative probability believed to produce a more accurate estimate of the probability under a certain condition can be increased in response to detecting the certain condition.

To avoid multiplication with floats and use bit-shifts only when computing the weighted sum, the weights $\omega_1$ and $\omega_2$ for two estimators can have several possible combinations of values:

- $\omega_1 = 0$, and $\omega_2 = 1$, and *cdfnewmix*[*i*] = 0 * *cdfnew*1[*i*] + 1 * *cdfnew*2[*i*] = *cdfnew*2[*i*]
- $\omega_1 = 1$, and $\omega_2 = 0$, and *cdfnewmix*[*i*] = 1 * *cdfnew*1[*i*] + 0 * *cdfnew*2[*i*] = *cdfnew*1[*i*]

- $\omega_1 = 1/2$, and $\omega_2 = 1/2$, and
$$cdfnewmix[i] = \frac{1}{2} * cdfnew1[i] + \frac{1}{2} *$$
*cdfnew*2[*i*] = (*cdfnew*1[*i*] + *cdfnew*2[*i*]) >> 1

When $\omega_1 = 0$, and $\omega_2 = 1$, *cdfnew*2[*i*] makes a contribution to the weighted sum, and *cdfnew*2[*i*] does not make a contribution to the weighted sum. When $\omega_1 = 1$, and $\omega_2 = 0$, *cdfnew*1[*i*] makes a contribution to the weighted sum, and *cdfnew*2[*i*] does not make a contribution to the weighted sum. When $\omega_1 = 1/2$, and $\omega_2 = 1/2$, *cdfnew*1[*i*] and *cdfnew*2[*i*] both make an equal/even contribution to the weighted sum.

For a mixture of two adaptive cumulative probability estimates, the weights [$\omega_1$, $\omega_2$] for the two adaptive cumulative probability estimates can change/switch/toggle between two or more of:

- [0, 1],
- [1, 0], and
- [1/2, 1/2].

For a mixture of three adaptive cumulative probability estimates, the weights [$\omega_1$, $\omega_2$, $\omega_3$] for the three adaptive cumulative probability estimates can change/switch/toggle between two or more of:

- [1, 0, 0],
- [0, 1, 0],
- [0, 0, 1],
- [1/2, 1/2, 0],
- [1/2, 0, 1/2],
- [0, 1/2, 1/2],
- [1/4, 1/4, 1/2],
- [1/4, 1/2, 1/4], and
- [1/2, 1/4, 1/4].

For a mixture of four adaptive cumulative probability estimates, the [$\omega_1$, $\omega_2$, $\omega_3$, $\omega_4$] for the four adaptive cumulative probability estimates can change/switch/toggle between two or more of:

- [1, 0, 0, 0],
- [0, 1, 0, 0],
- [0, 1, 0, 0],
- [0, 0, 0, 1],
- [1/2, 1/2, 0, 0],
- [1/2, 0, 1/2, 0],
- [1/2, 0, 0, 1/2],
- [0, 1/2, 1/2, 0],
- [0, 1/2, 0, 1/2],
- [0, 0, 1/2, 1/2],
- [1/4, 1/4, 1/4, 1/4],
- [1/8, 1/8, 1/4, 1/2],
- [1/8, 1/8, 1/2, 1/4],
- [1/4, 1/2, 1/8, 1/8],
- [1/2, 1/4, 1/8, 1/8],
- [1/8, 1/2, 1/4, 1/8],
- [1/8, 1/4, 1/2, 1/8],
- [1/4, 1/8, 1/8, 1/2],
- [1/2, 1/8, 1/8, 1/4],
- [1/4, 1/8, 1/2, 1/8],
- [1/2, 1/8, 1/4, 1/8],
- [1/8, 1/4, 1/8, 1/2], and
- [1/8, 1/2, 1/8, 1/4].

In some embodiments, the values for the weights, e.g., $\omega_1$ and $\omega_2$, can vary based on the index *i*, or the particular cumulative probability estimate being updated. In other words, the values for the weights may vary from symbol to symbol of the alphabet.

In some embodiments, the values of the weights, e.g., $\omega_1$ and $\omega_2$, can vary based on time (e.g., each new incoming symbol and how many symbols have been encoded).

In some embodiments, the values of the weights, e.g., $\omega_1$ and $\omega_2$, can vary based on the number of updates to the probability distribution (e.g., the counter stored in the table, *cdf*[*N*]).

In some embodiments, the values of the weights, e.g., $\omega_1$ and $\omega_2$, can vary based on one or more other statistics about the probability estimates.

*Determining a state of the probability estimate and changing the weights*

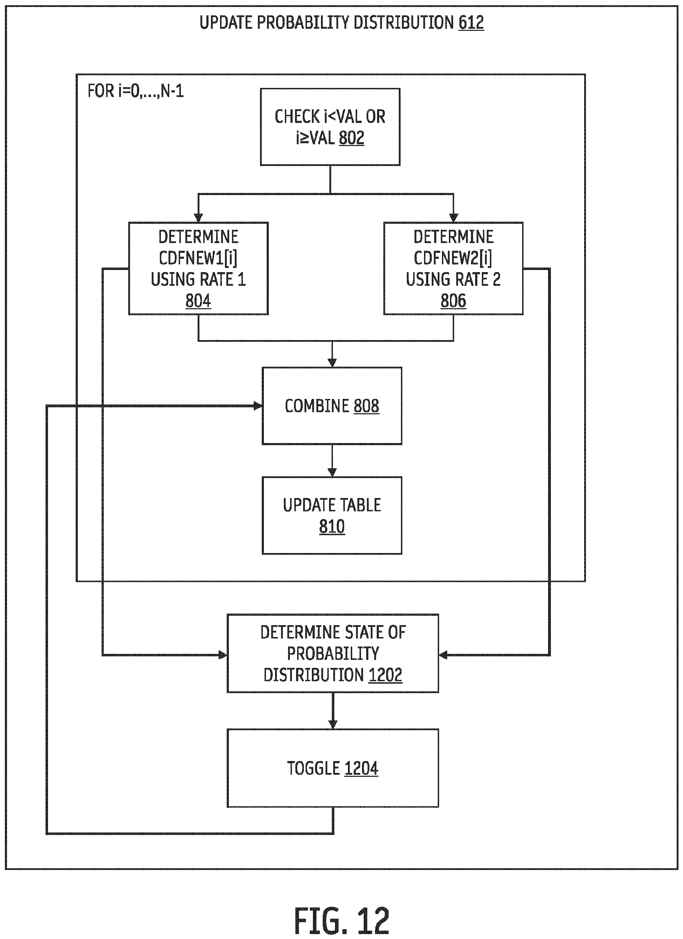

FIG. 12 illustrates updating probability distribution for adaptive multi-symbol arithmetic coding with state-dependent adaptation, according to some embodiments of the disclosure. An exemplary implementation of update probability distribution 612 is depicted.

In 1202, a state of the probability distribution or one or more cumulative probability estimates is determined. As illustrated in FIG. 9, a probability estimate may be steady for a number of incoming symbols, or for a period of time. The probability estimate may change suddenly. The state indicating whether the probability is changing or staying steady can be determined from the difference(s) (e.g., absolute value difference(s)) between the adaptive cumulative probability estimates determined in 804 and 806. If the difference(s) are not sufficiently high (e.g., if a maximum of the differences does not exceed a threshold) for a number of incoming symbols, the state for the period of the incoming symbols may be determined to be in steady state, e.g., suggesting that the probability distribution is in a steady region. If the difference(s) are sufficiently high (e.g., if a maximum of the differences exceeds a threshold) for a number of incoming symbols, the state for the period of the incoming symbols may be determined to be in changing state. Other techniques for determining state of the probability distribution can be implemented in 1202.

A state that is steady may be a condition where an adaptive cumulative probability estimate, that is determined using a slow adaptation rate, may be more accurate than an adaptive cumulative probability distribution estimate determined using a fast adaptation rate. A state that is changing may be a condition where an adaptive cumulative probability estimate, that is determined using a fast adaptation rate, may be more accurate (and quicker to reach the optimal probability) than an adaptive cumulative probability distribution estimate determined using a slow adaptation rate.

Adaptation behavior can change in response to the state in one or more ways. In some cases, adaptation behavior can change by modifying the weights used in combining two or more adaptive cumulative probability estimates (e.g., by changing contribution(s) of the adaptive cumulative probability estimates to the final cumulative probability estimates). Weights can be toggled or changed, to select or increase contribution of one or more adaptive cumulative probability estimates to the mixed cumulative probability estimate while decrease or remove contribution of one or more other adaptive cumulative probability estimates.

In 1204, adaptation behavior may be modified through toggling/switching/changing the weights that correspond to the adaptive cumulative probability estimates determined using different adaptation rates. The weights that correspond to the adaptive cumulative probability estimates, which may be determined using different adaptation rates, can be based on and/or can change based on a difference between a first adaptive cumulative probability estimate and a second adaptive cumulative probability estimate.

In some cases, in response to determining the maximum exceeds the threshold (e.g., state determined in 1202 indicating that the state is changing), contribution of one or more of the first adaptive cumulative probabilities computed using the first adaptation parameter (*cdfnew*1[*i*] for individual CDF indices, e.g., $i = 0, ..., N - 1$) may be removed from the calculation of the combined probability estimates of the probability distribution in toggle 1204 for a certain number of incoming symbols.

In some cases, the contribution of one or more adaptive cumulative probability estimates computed using a slow adaptation parameter is removed or reduced in toggle 1204, e.g., in response to detecting a changing state in 1202. The contribution of one or more adaptive cumulative probability estimates computed using a fast adaptation parameter can be increased in toggle 1204, e.g., in response to detecting a changing state in 1202.

In some cases, the contribution of one or more adaptive cumulative probability estimates computed using a fast adaptation parameter is removed or reduced in toggle 1204, e.g., in response to detecting a steady state in 1202. The contribution of one or more adaptive cumulative probability estimates computed using a slow adaptation parameter can be increased in toggle 1204, e.g., in response to detecting a steady state in 1202.

In some cases, the weights that correspond to the different adaptive cumulative probabilities used in calculating a weighted sum may change/switch/toggle in toggle 1204, e.g., in response to detecting a changing state or a steady state in 1204. In other words, the weights may depend on the state of the probability estimate as determined in 1202.

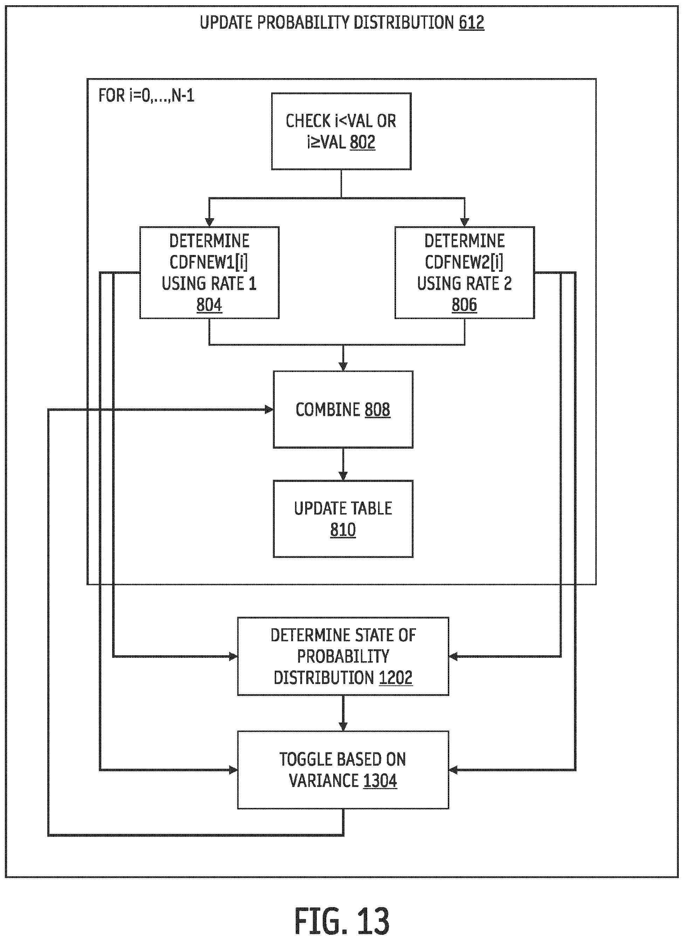

FIG. 13 illustrates updating probability distribution for adaptive multi-symbol arithmetic coding with state-dependent adaptation, according to some embodiments of the disclosure. The process illustrated in FIG. 13 is similar to the process in FIG. 12. However, rather than changing/switching/toggling weights of adaptive cumulative probability estimates based on the adaptation parameters as performed in toggle 1204 in FIG. 12, it is possible to change/switch/toggle weights of adaptive cumulative probability estimates based on the variances of the adaptive cumulative probability estimates in toggle based on variance 1304.

An adaptive cumulative probability estimate may have a corresponding variance that measures how much the adaptive cumulative probability estimate changes or vary with respect to the mean. The variance can be estimated based on a K number of past samples of the adaptive cumulative probability estimate, by calculating the average of the squared differences between each sample and the mean of the samples.

In some cases, 1202 may determine the state is steady. In such a scenario, toggle based on variance 1304 may increase a contribution of an adaptive cumulative probability estimate having a lower variance (likely due to the use of a slow adaptation rate) than other adaptive cumulative probability estimate(s) to the mixed cumulative probability estimate and decrease the contribution of the other adaptive cumulative probability estimate(s) to the mixed cumulative probability estimate.

In some cases, 1202 may determine the state is changing. In such a scenario, toggle based on variance 1304 may decrease a contribution of an adaptive cumulative probability estimate having a lower variance (likely due to the use of a slow adaptation rate) than other adaptive cumulative probability estimate(s) to the mixed cumulative probability estimate and increase the contribution of the other adaptive cumulative probability estimate(s) to the mixed cumulative probability estimate.

*Determining variances of the probability estimates and changing the weights*

The higher the variance of an adaptive cumulative probability estimate, the higher instability and uncertainty the adaptive cumulative probability estimate has. Based on this insight, the weights (defining contributions) used in the weighted sum can be set inversely related to the variance of the adaptive cumulative probability estimate. If variance is high, the weight can be set to decrease the contribution of the adaptive cumulative probability estimate to the final weighted sum. If variance is low, the weight can be set to increase the contribution of the adaptive cumulative probability estimate to the final weighted sum. If the variance is about the same as other variance(s), the weight can be set to be even/equal to other weight(s) to make the contributions even/equal.

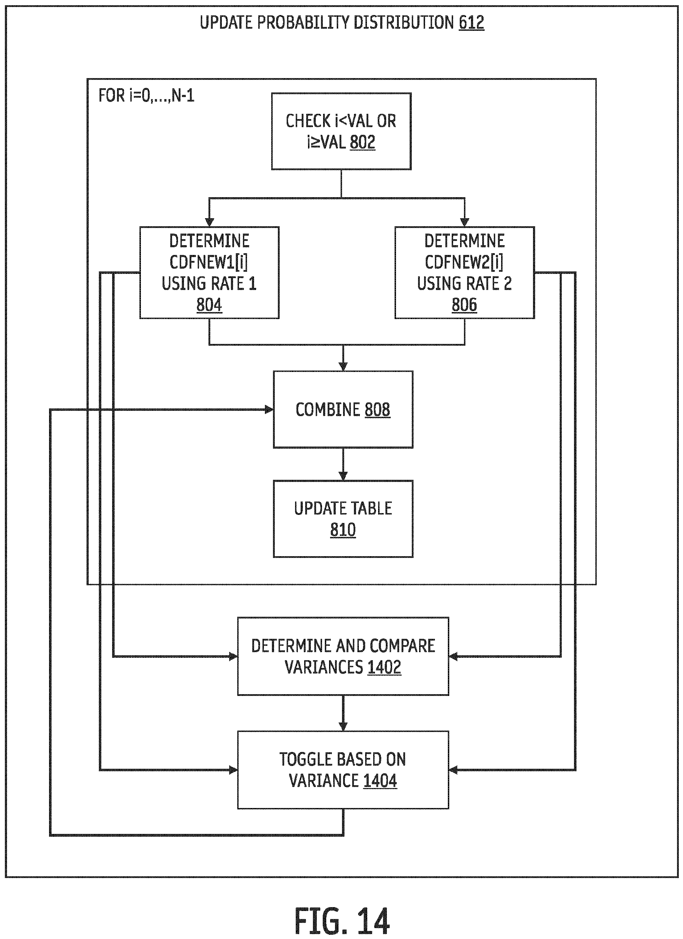

FIG. 14 illustrates updating probability distribution for adaptive multi-symbol arithmetic coding with variance-dependent adaptation, according to some embodiments of the disclosure. In 1402, variances of adaptive cumulative probability estimates (e.g., adaptive cumulative probability estimate from 804 and adaptive cumulative probability estimate from 806) can be determined. The variances may be compared against each other to determine which variance is higher than the other. The variance may signal which adaptive cumulative probability estimate should contribute more or less to the mixed cumulative probability estimate. In 1402, it may be determined that a first variance (Var1) corresponding to a first adaptive cumulative probability estimate is significantly higher than a second variance (Var2) corresponding to a second adaptive cumulative probability estimate. Var1 subtracted by Var2 may be greater than a threshold. In 1402, it may be determined that the second variance (Var2) is significantly higher than the first variance (Var1). Var2 subtracted by Var1 may be greater than a threshold. In 1402, it may be determined that the first variance (Var1) and the second variance (Var2) may be substantially the same or not significantly different. |Var1-Var2| may be less than a threshold.

The variances may cause the weights used in the weighted sum to change in toggle based on variance 1404. In other words, the weights corresponding to the adaptive cumulative probability estimates determined using different adaptation parameters may be based on and/or may change based on the variances of the adaptive cumulative probability estimates.

In some cases, when a variance of a first adaptive cumulative probability estimate of a particular symbol is significantly higher than a variance of a second adaptive cumulative probability estimate of the particular symbol (e.g., as determined in 1402), then, in toggle based on variance 1404, the contribution of the first adaptive cumulative probability estimate to the mixed cumulative probability estimate of the particular symbol may be decreased, and the contribution of the second adaptive probability estimate to the mixed cumulative probability estimate of the particular symbol may be increased.

In some cases, when a variance of a second adaptive cumulative probability estimate of a particular symbol is significantly higher than a variance of a first adaptive cumulative probability estimate of the particular symbol (e.g., as determined in 1402), then, in toggle based on variance 1404, the contribution of the second adaptive cumulative probability estimate to the mixed cumulative probability estimate of the particular symbol may be decreased, and the contribution of the first adaptive probability estimate to the mixed cumulative probability estimate of the particular symbol may be increased.

In some cases, when a variance of a first adaptive cumulative probability estimate of a particular symbol is about the same as a variance of a second adaptive cumulative probability estimate of the particular symbol (e.g., as determined in 1402), then, in toggle based on variance 1404, the contribution of the first adaptive cumulative probability estimate to the mixed cumulative probability estimate of the particular symbol, and the contribution of the second adaptive cumulative probability estimate to the mixed cumulative probability estimate of the particular symbol may be balanced or evened out.

*Exemplary method for multi-symbol arithmetic coding*

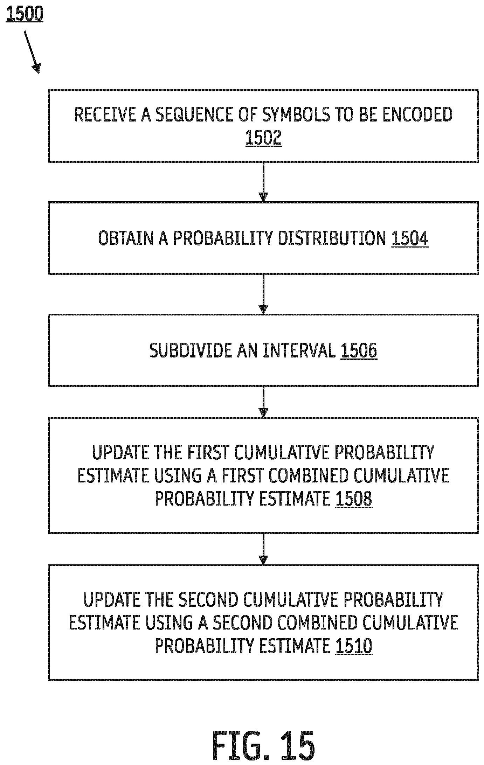

FIG. 15 depicts a flow diagram of an exemplary method 1500 for adaptive multi-symbol arithmetic coding, according to some embodiments of the disclosure. Method 1500 may be implemented on computing device 1600 as illustrated in FIG. 16.

In 1502, a sequence of symbols may be received at an entropy coder. The sequence of symbols is to be encoded as a compressed bitstream by the entropy coder.

In 1504, the entropy coder may obtain a probability distribution (e.g., a table or array of CDFs). The probability distribution may correspond to an alphabet (e.g., having N symbols). The probability distribution can include a first cumulative probability estimate corresponding to a first symbol in the alphabet, and a second cumulative probability estimate corresponding to a second symbol in the alphabet.

In 1506, the entropy coder may subdivide an interval into subintervals. The subintervals may correspond to the N symbols of the alphabet. The interval may be subdivided according to the first cumulative probability estimate, and the second cumulative probability estimate of the probability distribution obtained in 1204.

In 1508, the entropy coder may update the first cumulative probability estimate of the probability distribution using a first combined cumulative probability estimate computed based on at least two different adaptation parameters.

In 1510, the entropy coder may update the second cumulative probability estimate of the probability distribution using a second combined cumulative probability estimate based on the at least two different adaptation parameters.

*Exemplary computing device*

FIG. 16 is a block diagram of an apparatus or a system, e.g., an exemplary computing device 1600, according to some embodiments of the disclosure. One or more computing devices 1600 may be used to implement the functionalities described with the FIGS. and herein. A number of components are illustrated in the FIGS. can be included in the computing device 1600, but any one or more of these components may be omitted or duplicated, as suitable for the application. In some embodiments, some or all of the components included in the computing device 1600 may be attached to one or more motherboards. In some embodiments, some or all of these components are fabricated onto a single system on a chip (SoC) die. Additionally, in various embodiments, the computing device 1600 may not include one or more of the components illustrated in FIG. 16, and the computing device 1600 may include interface circuitry for coupling to the one or more components. For example, the computing device 1600 may not include a display device 1606, and may include display device interface circuitry (e.g., a connector and driver circuitry) to which a display device 1606 may be coupled. In another set of examples, the computing device 1600 may not include an audio input device 1618 or an audio output device 1608 and may include audio input or output device interface circuitry (e.g., connectors and supporting circuitry) to which an audio input device 1618 or audio output device 1608 may be coupled.

The computing device 1600 may include a processing device 1602 (e.g., one or more processing devices, one or more of the same type of processing device, one or more of different types of processing device). The processing device 1602 may include electronic circuitry that process electronic data from data storage elements (e.g., registers, memory, resistors, capacitors, quantum bit cells) to transform that electronic data into other electronic data that may be stored in registers and/or memory. Examples of processing device 1602 may include a central processing unit (CPU), a graphical processing unit (GPU), a quantum processor, a machine learning processor, an artificial intelligence processor, a neural network processor, an artificial intelligence accelerator, an application specific integrated circuit (ASIC), an analog signal processor, an analog computer, a microprocessor, a digital signal processor, a field programmable gate array (FPGA), a tensor processing unit (TPU), a data processing unit (DPU), etc.

The computing device 1600 may include a memory 1604, which may itself include one or more memory devices such as volatile memory (e.g., DRAM), nonvolatile memory (e.g., read-only memory (ROM)), high bandwidth memory (HBM), flash memory, solid state memory, and/or a hard drive. Memory 1604 includes one or more non-transitory computer-readable storage media. In some embodiments, memory 1604 may include memory that shares a die with the processing device 1602. In some embodiments, memory 1604 includes one or more non-transitory computer-readable media storing instructions executable to perform operations described with the FIGS. and herein, such as the methods described herein. Memory 1604 may include one or more non-transitory computer-readable media storing instructions executable to perform operations associated with one or more of: encoder 102, decoder 1...D $162_{1...D}$, update probability distribution 612, and method 1500. The instructions stored in the one or more non-transitory computer-readable media may be executed by processing device 1602. In some embodiments, memory 1604 may store data, e.g., data structures, binary data, bits, metadata, files, blobs, etc., as described with the FIGS. and herein. Memory 1604 may include one or more non-transitory computer-readable media storing one or more of: input frames to the encoder, intermediate data structures computed by the encoder, bitstream generated by the encoder, bitstream received by a decoder, intermediate data structures computed by the decoder, and reconstructed frames generated by the decoder. Memory 1604 may include one or more non-transitory computer-readable media storing one or more of: video frames 104, encoded bitstream 180, and decoded video 1...D $162_{1...D}$.

In some embodiments, the computing device 1600 may include a communication device 1612 (e.g., one or more communication devices). For example, the communication device 1612 may be configured for managing wired and/or wireless communications for the transfer of data to and from the computing device 1600. The term "wireless" and its derivatives may be used to describe circuits, devices, systems, methods, techniques, communications channels, etc., that may communicate data through the use of modulated electromagnetic radiation through a nonsolid medium. The term does not imply that the associated devices do not contain any wires, although in some embodiments they might not. The communication device 1612 may implement any of a number of wireless standards or protocols, including but not limited to Institute for Electrical and Electronic Engineers (IEEE) standards including Wi-Fi (IEEE 802.10 family), IEEE 802.16 standards (e.g., IEEE 802.16-2005 Amendment), Long-Term Evolution (LTE) project along with any amendments, updates, and/or revisions (e.g., advanced LTE project, ultramobile broadband (UMB) project (also referred to as "3GPP2"), etc.). IEEE 802.16 compatible Broadband Wireless Access (BWA) networks are generally referred to as WiMAX networks, an acronym that stands for worldwide interoperability for microwave access, which is a certification mark for products that pass conformity and interoperability tests for the IEEE 802.16 standards. The communication device 1612 may operate in accordance with a Global System for Mobile Communication (GSM), General Packet Radio Service (GPRS), Universal Mobile Telecommunications System (UMTS), High Speed Packet Access (HSPA), Evolved HSPA (E-HSPA), or LTE network. The communication device 1612 may operate in accordance with Enhanced Data for GSM Evolution (EDGE), GSM EDGE Radio Access Network (GERAN), Universal Terrestrial Radio Access Network (UTRAN), or Evolved UTRAN (E-UTRAN). The communication device 1612 may operate in accordance with Code-division Multiple Access (CDMA), Time Division Multiple Access (TDMA), Digital Enhanced Cordless Telecommunications (DECT), Evolution-Data Optimized (EV-DO), and derivatives thereof, as well as any other wireless protocols that are designated as 3G, 4G, 5G, and beyond. The communication device 1612 may operate in accordance with other wireless protocols in other embodiments. The computing device 1600 may include an antenna 1622 to facilitate wireless communications and/or to receive other wireless communications (such as radio frequency transmissions). The computing device 1600 may include receiver circuits and/or transmitter circuits. In some embodiments, the communication device 1612 may manage wired communications, such as electrical, optical, or any other suitable communication protocols (e.g., the Ethernet). As noted above, the communication device 1612 may include multiple communication chips. For instance, a first communication device 1612 may be dedicated to shorter-range wireless communications such as Wi-Fi or Bluetooth, and a second communication device 1612 may be dedicated to longer-range wireless communications such as global positioning system (GPS), EDGE, GPRS, CDMA, WiMAX, LTE, EV-DO, or others. In some embodiments, a first communication device 1612 may be dedicated to wireless communications, and a second communication device 1612 may be dedicated to wired communications.

The computing device 1600 may include power source / power circuitry 1614. The power source / power circuitry 1614 may include one or more energy storage devices (e.g., batteries or capacitors) and/or circuitry for coupling components of the computing device 1600 to an energy source separate from the computing device 1600 (e.g., DC power, AC power, etc.).

The computing device 1600 may include a display device 1606 (or corresponding interface circuitry, as discussed above). The display device 1606 may include any visual indicators, such as a heads-up display, a computer monitor, a projector, a touchscreen display, a liquid crystal display (LCD), a light-emitting diode display, or a flat panel display, for example.

The computing device 1600 may include an audio output device 1608 (or corresponding interface circuitry, as discussed above). The audio output device 1608 may include any device that generates an audible indicator, such as speakers, headsets, or earbuds, for example.

The computing device 1600 may include an audio input device 1618 (or corresponding interface circuitry, as discussed above). The audio input device 1618 may include any device that generates a signal representative of a sound, such as microphones, microphone arrays, or digital instruments (e.g., instruments having a musical instrument digital interface (MIDI) output).

The computing device 1600 may include a GPS device 1616 (or corresponding interface circuitry, as discussed above). The GPS device 1616 may be in communication with a satellite-based system and may receive a location of the computing device 1600, as known in the art.

The computing device 1600 may include a sensor 1630 (or one or more sensors). The computing device 1600 may include corresponding interface circuitry, as discussed above). Sensor 1630 may sense physical phenomenon and translate the physical phenomenon into electrical signals that can be processed by, e.g., processing device 1602. Examples of sensor 1630 may include: capacitive sensor, inductive sensor, resistive sensor, electromagnetic field sensor, light sensor, camera, imager, microphone, pressure sensor, temperature sensor, vibrational sensor, accelerometer, gyroscope, strain sensor, moisture sensor, humidity sensor, distance sensor, range sensor, time-of-flight sensor, pH sensor, particle sensor, air quality sensor, chemical sensor, gas sensor, biosensor, ultrasound sensor, a scanner, etc.

The computing device 1600 may include another output device 1610 (or corresponding interface circuitry, as discussed above). Examples of the other output device 1610 may include an audio codec, a video codec, a printer, a wired or wireless transmitter for providing information to other devices, haptic output device, gas output device, vibrational output device, lighting output device, home automation controller, or an additional storage device.

The computing device 1600 may include another input device 1620 (or corresponding interface circuitry, as discussed above). Examples of the other input device 1620 may include an accelerometer, a gyroscope, a compass, an image capture device, a keyboard, a cursor control device such as a mouse, a stylus, a touchpad, a bar code reader, a Quick Response (QR) code reader, any sensor, or a radio frequency identification (RFID) reader.

The computing device 1600 may have any desired form factor, such as a handheld or mobile computer system (e.g., a cell phone, a smart phone, a mobile Internet device, a music player, a tablet computer, a laptop computer, a netbook computer, a personal digital assistant (PDA), an ultramobile personal computer, a remote control, wearable device, headgear, eyewear, footwear, electronic clothing, etc.), a desktop computer system, a server or other networked computing component, a printer, a scanner, a monitor, a set-top box, an entertainment control unit, a vehicle control unit, a digital camera, a digital video recorder, an Internet-of-Things device, or a wearable computer system. In some embodiments, the computing device 1600 may be any other electronic device that processes data.

*<u>Select examples</u>*

Example 1 provides a method, including receiving symbols to be encoded as a compressed bitstream; obtaining a probability distribution, where the probability distribution corresponds to an alphabet, the probability distribution includes a first cumulative probability estimate corresponding to a first symbol in the alphabet and a second cumulative probability estimate corresponding to a second symbol in the alphabet, and the alphabet has a dictionary size of at least two symbols; subdividing an interval according to the first cumulative probability estimate and the second cumulative probability estimate; updating the first cumulative probability estimate of the probability distribution using a first combined cumulative probability estimate computed based on at least two adaptation parameters; and updating the second cumulative probability estimate of the probability distribution using a second combined cumulative probability estimate based on the at least two adaptation parameters.

Example 2 provides the method of example 1, further including determining first adaptive cumulative probability estimates corresponding to the symbols in the alphabet based on a first adaptation parameter; and determining second adaptive cumulative probability estimates corresponding to the symbols in the alphabet based on a second adaptation parameter.

Example 3 provides the method of example 2, further including determining a maximum of per-symbol absolute differences between the first adaptive cumulative probability estimates and the second adaptive cumulative probability estimates; and determining whether the maximum exceeds a threshold.

Example 4 provides the method of example 3, further including in response to determining the maximum exceeds the threshold, removing a contribution of the first adaptive cumulative probability estimates determined based on the first adaptation parameter in updating combined cumulative probability estimates of the probability distribution.

Example 5 provides the method of example 3 or 4, further including in response to determining the maximum exceeds the threshold, setting a counter of the probability distribution to zero.

Example 6 provides the method of any one of examples 1-5, where: a current symbol appears in the symbols; and the method further includes selecting a subinterval in the interval corresponding to the current symbol in the symbols; and writing one or more bits according to the subinterval to the compressed bitstream.

Example 7 provides the method of example 6, further including obtaining an updated probability distribution having an updated first cumulative probability estimate and an updated second cumulative probability estimate; and subdividing the subinterval according to the updated probability distribution.

Example 8 provides the method of any one of examples 1-7, where: the at least two adaptation parameters include a first adaptation parameter and a second adaptation parameter; the first adaptation parameter sets a first speed of adaptation for a first adaptive cumulative probability estimate; and the first adaptation parameter sets a second speed of adaptation for a second adaptive cumulative probability estimate, the second speed being different from the first speed.

Example 9 provides the method of any one of examples 1-8, where subdividing the interval includes subdividing the interval into at least three subintervals according to the probability distribution.

Example 10 provides the method of any one of examples 1-9, where the at least two adaptation parameters are specific to the probability distribution.

Example 11 provides the method of any one of examples 1-10, where the first combined cumulative probability estimate is computed by: determining a first adaptive cumulative probability estimate based on a first adaptation parameter and a first memory of the first adaptive cumulative probability estimate; and determining a second adaptive cumulative probability estimate based on a second adaptation parameter and a second memory of the second adaptive cumulative probability estimate.

Example 12 provides the method of example 11, where the first combined cumulative probability estimate is computed by: summing the first adaptive cumulative probability estimate and the second adaptive cumulative probability estimate to determine a sum; and applying a bit-shift to the sum.

Example 13 provides the method of example 11 or 12, where the first combined cumulative probability estimate is computed by: computing a weighted sum of the first adaptive cumulative probability estimate and the second adaptive cumulative probability estimate to determine a weighted sum.

Example 14 provides the method of example 13, where: a first weight corresponding to the first adaptive cumulative probability estimate and a second weight corresponding to the second adaptive cumulative probability estimate depend on one or more of: a first variance associated with the first adaptive cumulative probability estimate and a second variance associated with the second adaptive cumulative probability estimate.

Example 15 provides the method of example 13 or 14, where: a first weight corresponding to the first adaptive cumulative probability estimate and a second weight corresponding to the second adaptive cumulative probability estimate depend on a difference between the first adaptive cumulative probability estimate and the second adaptive cumulative probability estimate.

Example 16 provides one or more non-transitory computer-readable media storing instructions executable to perform operations, the operations including receiving symbols to be encoded as a compressed bitstream; obtaining a probability distribution, where the probability distribution corresponds to an alphabet, the probability distribution includes a first cumulative probability estimate corresponding to a first symbol in the alphabet and a second cumulative probability estimate corresponding to a second symbol in the alphabet, and the alphabet has a dictionary size of at least two symbols; subdividing an interval according to the first cumulative probability estimate and the second cumulative probability estimate; updating the first cumulative probability estimate of the probability distribution using a first combined cumulative probability estimate computed based on at least two adaptation parameters; and updating the second cumulative probability estimate of the probability distribution using a second combined cumulative probability estimate based on the at least two adaptation parameters.

Example 17 provides the one or more non-transitory computer-readable media of example 16, where the operations further include determining first adaptive cumulative probability estimates corresponding to the symbols in the alphabet based on a first adaptation parameter; and determining second adaptive cumulative probability estimates corresponding to the symbols in the alphabet based on a second adaptation parameter.

Example 18 provides the one or more non-transitory computer-readable media of example 17, where the operations further include determining a maximum of per-symbol absolute differences between the first adaptive cumulative probability estimates and the second adaptive cumulative probability estimates; and determining whether the maximum exceeds a threshold.

Example 19 provides the one or more non-transitory computer-readable media of example 18, where the operations further include in response to determining the maximum exceeds the threshold, removing a contribution of the first adaptive cumulative probability estimates determined based on the first adaptation parameter in updating combined cumulative probability estimates of the probability distribution.

Example 20 provides the one or more non-transitory computer-readable media of example 18 or 19, where the operations further include in response to determining the maximum exceeds the threshold, setting a counter of the probability distribution to zero.

Example 21 provides the one or more non-transitory computer-readable media of any one of examples 16-20, where: a current symbol appears in the symbols; and the operations further include selecting a subinterval in the interval corresponding to the current symbol in the symbols; and writing one or more bits according to the subinterval to the compressed bitstream.

Example 22 provides the one or more non-transitory computer-readable media of example 21, where the operations further include obtaining an updated probability distribution having an updated first cumulative probability estimate and an updated second cumulative probability estimate; and subdividing the subinterval according to the updated probability distribution.

Example 23 provides the one or more non-transitory computer-readable media of any one of examples 16-22, where: the at least two adaptation parameters include a first adaptation parameter and a second adaptation parameter; the first adaptation parameter sets a first speed of adaptation for a first adaptive cumulative probability estimate; and the first adaptation parameter sets a second speed of adaptation for a second adaptive cumulative probability estimate, the second speed being different from the first speed.

Example 24 provides the one or more non-transitory computer-readable media of any one of examples 16-23, where subdividing the interval includes subdividing the interval into at least three subintervals according to the probability distribution.

Example 25 provides the one or more non-transitory computer-readable media of any one of examples 16-24, where the at least two adaptation parameters are specific to the probability distribution.

Example 26 provides the one or more non-transitory computer-readable media of any one of examples 16-25, where the first combined cumulative probability estimate is computed by: determining a first adaptive cumulative probability estimate based on a first adaptation parameter and a first memory of the first adaptive cumulative probability estimate; and determining a second adaptive cumulative probability estimate based on a second adaptation parameter and a second memory of the second adaptive cumulative probability estimate.

Example 27 provides the one or more non-transitory computer-readable media of example 26, where the first combined cumulative probability estimate is computed by: summing the first adaptive cumulative probability estimate and the second adaptive cumulative probability estimate to determine a sum; and applying a bit-shift to the sum.

Example 28 provides the one or more non-transitory computer-readable media of example 26 or 27, where the first combined cumulative probability estimate is computed by: computing a weighted sum of the first adaptive cumulative probability estimate and the second adaptive cumulative probability estimate to determine a weighted sum.

Example 29 provides the one or more non-transitory computer-readable media of example 28, where: a first weight corresponding to the first adaptive cumulative probability estimate and a second weight corresponding to the second adaptive cumulative probability estimate depend on one or more of: a first variance associated with the first adaptive cumulative probability estimate and a second variance associated with the second adaptive cumulative probability estimate.

Example 30 provides the one or more non-transitory computer-readable media of example 28 or 29, where: a first weight corresponding to the first adaptive cumulative probability estimate and a second weight corresponding to the second adaptive cumulative probability estimate depend on a difference between the first adaptive cumulative probability estimate and the second adaptive cumulative probability estimate.

Example 31 provides a computing device, including one or more processing devices; and one or more memories to store instructions for an encoder, which when executed by the one or more processing devices, cause the one or more processing devices to: receive symbols to be encoded as a compressed bitstream; obtain a probability distribution, where the probability distribution corresponds to an alphabet, the probability distribution includes a first cumulative probability estimate corresponding to a first symbol in the alphabet and a second cumulative probability estimate corresponding to a second symbol in the alphabet, and the alphabet has a dictionary size of at least two symbols; subdivide an interval according to the first cumulative probability estimate and the second cumulative probability estimate; update the first cumulative probability estimate of the probability distribution using a first combined cumulative probability estimate computed based on at least two adaptation parameters; and update the second cumulative probability estimate of the probability distribution using a second combined cumulative probability estimate based on the at least two adaptation parameters.

Example 32 provides the computing device of example 31, where the instructions further cause the one or more processing devices to: determining first adaptive cumulative probability estimates corresponding to the symbols in the alphabet based on a first adaptation parameter; and determining second adaptive cumulative probability estimates corresponding to the symbols in the alphabet based on a second adaptation parameter.

Example 33 provides the computing device of example 32, where the instructions further cause the one or more processing devices to: determining a maximum of per-symbol absolute differences between the first adaptive cumulative probability estimates and the second adaptive cumulative probability estimates; and determining whether the maximum exceeds a threshold.

Example 34 provides the computing device of example 33, where the instructions further cause the one or more processing devices to: in response to determining the maximum exceeds the threshold, removing a contribution of the first adaptive cumulative probability estimates determined based on the first adaptation parameter in updating combined cumulative probability estimates of the probability distribution.

Example 35 provides the computing device of example 33 or 34, where the instructions further cause the one or more processing devices to: in response to determining the maximum exceeds the threshold, setting a counter of the probability distribution to zero.

Example 36 provides the computing device of any one of examples 31-35, where: a current symbol appears in the symbols; and the instructions further cause the one or more processing devices to: selecting a subinterval in the interval corresponding to the current symbol in the symbols; and writing one or more bits according to the subinterval to the compressed bitstream.

Example 37 provides the computing device of example 36, further including obtaining an updated probability distribution having an updated first cumulative probability estimate and an updated second cumulative probability estimate; and subdividing the subinterval according to the updated probability distribution.

Example 38 provides the computing device of any one of examples 31-37, where: the at least two adaptation parameters include a first adaptation parameter and a second adaptation parameter; the first adaptation parameter sets a first speed of adaptation for a first adaptive cumulative probability estimate; and the first adaptation parameter sets a second speed of adaptation for a second adaptive cumulative probability estimate, the second speed being different from the first speed.

Example 39 provides the computing device of any one of examples 31-38, where subdividing the interval includes subdividing the interval into at least three subintervals according to the probability distribution.

Example 40 provides the computing device of any one of examples 31-39, where the at least two adaptation parameters are specific to the probability distribution.

Example 41 provides the computing device of any one of examples 31-40, where the first combined cumulative probability estimate is computed by: determining a first adaptive cumulative probability estimate based on a first adaptation parameter and a first memory of the first adaptive cumulative probability estimate; and determining a second adaptive cumulative probability estimate based on a second adaptation parameter and a second memory of the second adaptive cumulative probability estimate.

Example 42 provides the computing device of example 41, where the first combined cumulative probability estimate is computed by: summing the first adaptive cumulative probability estimate and the second adaptive cumulative probability estimate to determine a sum; and applying a bit-shift to the sum.

Example 43 provides the computing device of example 41 or 42, where the first combined cumulative probability estimate is computed by: computing a weighted sum of the first adaptive cumulative probability estimate and the second adaptive cumulative probability estimate to determine a weighted sum.

Example 44 provides the computing device of example 43, where: a first weight corresponding to the first adaptive cumulative probability estimate and a second weight corresponding to the second adaptive cumulative probability estimate depend on one or more of: a first variance associated with the first adaptive cumulative probability estimate and a second variance associated with the second adaptive cumulative probability estimate.

Example 45 provides the computing device of example 43 or 44, where: a first weight corresponding to the first adaptive cumulative probability estimate and a second weight corresponding to the second adaptive cumulative probability estimate depend on a difference between the first adaptive cumulative probability estimate and the second adaptive cumulative probability estimate.

Example 46 is an apparatus comprising means to carry out or means for carrying out any one of the methods of examples 1-15.

### *Variations and other notes*

Although the operations of the example method shown in and described with reference to FIGS. 6, 8, 11-15 are illustrated as occurring once each and in a particular order, it will be recognized that the operations may be performed in any suitable order and repeated as desired. Additionally, one or more operations may be performed in parallel. Furthermore, the operations illustrated in FIGS. 6, 8, 11-15 may be combined or may include more or fewer details than described.

The above description of illustrated implementations of the disclosure, including what is described in the Abstract, is not intended to be exhaustive or to limit the disclosure to the precise forms disclosed. While specific implementations of, and examples for, the disclosure are described herein for illustrative purposes, various equivalent modifications are possible within the scope of the disclosure, as those skilled in the relevant art will recognize. These modifications may be made to the disclosure in light of the above detailed description.

For purposes of explanation, specific numbers, materials and configurations are set forth in order to provide a thorough understanding of the illustrative implementations. However, it will be apparent to one skilled in the art that the present disclosure may be practiced without the specific details and/or that the present disclosure may be practiced with only some of the described aspects. In other instances, well known features are omitted or simplified in order not to obscure the illustrative implementations.

Further, references are made to the accompanying drawings that form a part hereof, and in which are shown, by way of illustration, embodiments that may be practiced. It is to be understood that other embodiments may be utilized, and structural or logical changes may be made without departing from the scope of the present disclosure. Therefore, the following detailed description is not to be taken in a limiting sense.

Various operations may be described as multiple discrete actions or operations in turn, in a manner that is most helpful in understanding the disclosed subject matter. However, the order of description should not be construed as to imply that these operations are necessarily order dependent. In particular, these operations may not be performed in the order of presentation. Operations described may be performed in a different order from the described embodiment. Various additional operations may be performed or described operations may be omitted in additional embodiments.

For the purposes of the present disclosure, the phrase "A or B" or the phrase "A and/or B" means (A), (B), or (A and B). For the purposes of the present disclosure, the phrase "A, B, or C" or the phrase "A, B, and/or C" means (A), (B), (C), (A and B), (A and C), (B and C), or (A, B, and C). The term "between," when used with reference to measurement ranges, is inclusive of the ends of the measurement ranges.

The description uses the phrases "in an embodiment" or "in embodiments," which may each refer to one or more of the same or different embodiments. The terms "comprising," "including," "having," and the like, as used with respect to embodiments of the present disclosure, are synonymous. The disclosure may use perspective-based descriptions such as "above," "below," "top," "bottom," and "side" to explain various features of the drawings, but these terms are simply for ease of discussion, and do not imply a desired or required orientation. The accompanying drawings are not necessarily drawn to scale. Unless otherwise specified, the use of the ordinal adjectives "first," "second," and "third," etc., to describe a common object, merely indicates that different instances of like objects are being referred to and are not intended to imply that the objects so described must be in a given sequence, either temporally, spatially, in ranking or in any other manner.

In the following detailed description, various aspects of the illustrative implementations will be described using terms commonly employed by those skilled in the art to convey the substance of their work to others skilled in the art.

The terms "substantially," "close," "approximately," "near," and "about," generally refer to being within +/- 20% of a target value as described herein or as known in the art. Similarly, terms indicating orientation of various elements, e.g., "coplanar," "perpendicular," "orthogonal," "parallel," or any other angle between the elements, generally refer to being within +/- 5-20% of a target value as described herein or as known in the art.

In addition, the terms "comprise," "comprising," "include," "including," "have," "having" or any other variation thereof, are intended to cover a non-exclusive inclusion. For example, a method, process, or device, that comprises a list of elements is not necessarily limited to only those elements but may include other elements not expressly listed or inherent to such method, process, or device. Also, the term "or" refers to an inclusive "or" and not to an exclusive "or."

The systems, methods and devices of this disclosure each have several innovative aspects, no single one of which is solely responsible for all desirable attributes disclosed herein. Details of one or more implementations of the subject matter described in this specification are set forth in the description and the accompanying drawings.

**Claims**

1. A method, comprising:

   receiving symbols to be encoded as a compressed bitstream;
   obtaining a probability distribution, wherein the probability distribution corresponds to an alphabet, the probability distribution comprises a first cumulative probability estimate corresponding to a first symbol in the alphabet and a second cumulative probability estimate corresponding to a second symbol in the alphabet, and the alphabet has a dictionary size of at least two symbols;
   subdividing an interval according to the first cumulative probability estimate and the second cumulative probability estimate;
   updating the first cumulative probability estimate of the probability distribution using a first combined cumulative probability estimate computed based on at least two adaptation parameters; and
   updating the second cumulative probability estimate of the probability distribution using a second combined cumulative probability estimate based on the at least two adaptation parameters.

2. The method of claim 1, further comprising:

   determining first adaptive cumulative probability estimates corresponding to the symbols in the alphabet based on a first adaptation parameter; and
   determining second adaptive cumulative probability estimates corresponding to the symbols in the alphabet based on a second adaptation parameter.

3. The method of claim 2, further comprising:

   determining a maximum of per-symbol absolute differences between the first adaptive cumulative probability estimates and the second adaptive cumulative probability estimates; and
   determining whether the maximum exceeds a threshold.

4. The method of claim 3, further comprising:
   in response to determining the maximum exceeds the threshold, removing a contribution of the first adaptive cumulative probability estimates determined based on the first adaptation parameter in updating combined cumulative probability estimates of the probability distribution.

5. The method of claim 3 or 4, further comprising:
   in response to determining the maximum exceeds the threshold, setting a counter of the probability distribution to zero.

6. The method of any one of claims 1-5, wherein:

   a current symbol appears in the symbols; and
   the method further comprises:

   selecting a subinterval in the interval corresponding to the current symbol in the symbols; and
   writing one or more bits according to the subinterval to the compressed bitstream.

7. The method of claim 6, further comprising:

   obtaining an updated probability distribution having an updated first cumulative probability estimate and an updated second cumulative probability estimate; and
   subdividing the subinterval according to the updated probability distribution.

8. The method of any one of claims 1-7, wherein:

   the at least two adaptation parameters comprise a first adaptation parameter and a second adaptation parameter;
   the first adaptation parameter sets a first speed of adaptation for a first adaptive cumulative probability estimate; and
   the first adaptation parameter sets a second speed of adaptation for a second adaptive cumulative probability estimate, the second speed being different from the first speed.

9. The method of any one of claims 1-8, wherein subdividing the interval comprises:
   subdividing the interval into at least three subintervals according to the probability distribution.

10. The method of any one of claims 1-9, wherein the first combined cumulative probability estimate is computed by:

    determining a first adaptive cumulative probability estimate based on a first adaptation parameter and a first memory of the first adaptive cumulative probability estimate; and
    determining a second adaptive cumulative probability estimate based on a second adaptation parameter and a second memory of the second adaptive cumulative probability estimate.

11. The method of claim 10, wherein the first combined cumulative probability estimate is computed by:

    summing the first adaptive cumulative probability estimate and the second adaptive cumulative probability estimate to determine a sum; and
    applying a bit-shift to the sum.

12. The method of claim 10 or 11, wherein the first combined cumulative probability estimate is computed by:
    computing a weighted sum of the first adaptive cumulative probability estimate and the second adaptive cumulative probability estimate to determine a weighted sum.

13. The method of claim 12, wherein:

    a first weight corresponding to the first adaptive cumulative probability estimate and a second weight corresponding to the second adaptive cumulative probability estimate depend on one or more of: a first variance associated with the first adaptive cumulative probability estimate and a second variance associated with the second adaptive cumulative probability estimate; or
    a first weight corresponding to the first adaptive cumulative probability estimate and a second weight corresponding to the second adaptive cumulative probability estimate depend on a difference between the first adaptive cumulative probability estimate and the second adaptive cumulative probability estimate.

14. One or more non-transitory computer-readable media storing instructions executable to perform operations of a method according to any one of claims 1-13.

15. A computing device, comprising:

    one or more processing devices; and

one or more memories to store instructions for an encoder, which when executed by the one or more processing devices, cause the one or more processing devices to of a method according to any one of claims 1-13.

ENCODING SYSTEM 130

VIDEO FRAMES 104

ENCODER 102

ENCODED BITSTREAM 180 (e.g., 0 1 0 1 1 0...)

NETWORK 140

ENCODED BITSTREAM 180 (e.g., 0 1 0 1 1 0...)

DECODER 1 $162_1$

$168_1$

DISPLAY DEVICE 1 $164_1$

DECODING SYSTEM 1 $150_1$

DECODER 2 $162_2$

$168_2$

DISPLAY DEVICE 2 $164_2$

DECODING SYSTEM 2 $150_2$

...

DECODER D $162_D$

$168_D$

DISPLAY DEVICE D $164_D$

DECODING SYSTEM D $150_D$

FIG. 1

FIG. 2

ENCODED
BITSTREAM 180
(e.g., 0 1 0 1 1 0...)

QUANTIZED
TRANSFORM COEFFICIENTS AND
SYNTAX ELEMENTS 278

ENTROPY DECODING
302

INVERSE TRANSFORM
AND INVERSE
QUANTIZATION 218

PREDICTED
SAMPLES
212

RECONSTRUCTED
PREDICTED
RESIDUES 224

MODE
SELECTION
230

222

INTRA-FRAME
PREDICTION 238

RECONSTRUCTED
PREDICTED
SAMPLES 226

DECODED
VIDEO
168₁

INTER-FRAME
PREDICTION 236

IN-LOOP FILTER
228

DECODED
PICTURE
BUFFER 232

DECODER 1 162₁

FIG. 3

FIG. 4

PROBABILITY

FIG. 5

QUANTIZED
TRANSFORM COEFFICIENTS AND
SYNTAX ELEMENTS 278

ENTROPY CODING 216

OBTAIN PROBABILITY
DISTRIBUTION 602

INTERVAL
SUBDIVISION 604

SUBINTERVAL
SELECTION 606

RENORMALIZATION
AND BIT WRITING 608

UPDATE
PROBABILITY
DISTRIBUTION 612

ENCODED
BITSTREAM 180
(e.g., 0 1 0 1 1 0...)

FIG. 6

$$u=((range >> 8) *fl >> 6) >> 1) + 4* (N - (value - 1));$$
$$v=((range >> 8) *fh >> 6) >> 1) + 4* (N - (value + 0))$$

# FIG. 7

UPDATE PROBABILITY DISTRIBUTION 612

FOR i=0,...,N-1

CHECK i<VAL OR
i≥VAL 802

DETERMINE
CDFNEW1[i]
USING RATE 1
804

DETERMINE
CDFNEW2[i]
USING RATE 2
806

COMBINE 808

UPDATE TABLE
810

FIG. 8

FIG. 9

FIG. 10

UPDATE PROBABILITY DISTRIBUTION 612

FOR i=0,...,N-1

CHECK i<VAL OR
i≥VAL 802

DETERMINE
CDFNEW1[i]
USING RATE 1
804

DETERMINE
CDFNEW2[i]
USING RATE 2
806

COMBINE 808

UPDATE TABLE
810

SHIFT
DETECTED?
1102

YES

NO

RESET 1104

FIG. 11

UPDATE PROBABILITY DISTRIBUTION 612

FOR i=0,...,N-1

CHECK i<VAL OR
i≥VAL 802

DETERMINE
CDFNEW1[i]
USING RATE 1
804

DETERMINE
CDFNEW2[i]
USING RATE 2
806

COMBINE 808

UPDATE TABLE
810

DETERMINE STATE OF
PROBABILITY
DISTRIBUTION 1202

TOGGLE 1204

FIG. 12

FIG. 13

UPDATE PROBABILITY DISTRIBUTION 612

FOR i=0,...,N-1

CHECK i<VAL OR
i≥VAL 802

DETERMINE
CDFNEW1[i]
USING RATE 1
804

DETERMINE
CDFNEW2[i]
USING RATE 2
806

COMBINE 808

UPDATE TABLE
810

DETERMINE AND COMPARE
VARIANCES 1402

TOGGLE BASED ON
VARIANCE 1404

FIG. 14

1500

```
RECEIVE A SEQUENCE OF SYMBOLS TO BE ENCODED
                      1502
```

```
OBTAIN A PROBABILITY DISTRIBUTION 1504
```

```
SUBDIVIDE AN INTERVAL 1506
```

```
UPDATE THE FIRST CUMULATIVE PROBABILITY
ESTIMATE USING A FIRST COMBINED CUMULATIVE
        PROBABILITY ESTIMATE 1508
```

```
UPDATE THE SECOND CUMULATIVE PROBABILITY
ESTIMATE USING A SECOND COMBINED CUMULATIVE
         PROBABILITY ESTIMATE 1510
```

# FIG. 15

COMPUTING DEVICE 1600

MEMORY 1604

104   180   168₁,...,D

102   162₁,...,D

612

1500

PROCESSING DEVICE
1602

ANTENNA 1622

COMMUNICATION DEVICE
1612

DISPLAY DEVICE
1606

GPS DEVICE
1616

POWER
SOURCE /
POWER
CIRCUITRY
1614

AUDIO OUTPUT DEVICE
1608

AUDIO INPUT DEVICE
1618

OTHER OUTPUT DEVICE
1610

OTHER INPUT DEVICE
1620

SENSOR
1630

FIG. 16

## EUROPEAN SEARCH REPORT

Application Number

EP 24 20 3465

### DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| X | HAASE PAUL ET AL: "State-Based Multi-parameter Probability Estimation for Context-Based Adaptive Binary Arithmetic Coding", 2020 DATA COMPRESSION CONFERENCE (DCC), IEEE, 24 March 2020 (2020-03-24), pages 163-172, XP033776029, DOI: 10.1109/DCC47342.2020.00024 [retrieved on 2020-06-01] * pages 163-169 * | 1-3,6-15 | INV. H04N19/13 H03M7/30 H03M7/40 H04N19/91 |
| A | Aishin Alexander ET AL: "HIGH PRECISION PROBABILITY ESTIMATION FOR CABAC", , 30 November 2013 (2013-11-30), XP093252538, Retrieved from the Internet: URL:https://ieeexplore.ieee.org/stampPDF/g etPDF.jsp?tp=&arnumber=6706454&ref=aHR0cHM 6Ly9pZWVleHBsb3JlLmllZWUub3JnL2Fic3RyYWN0L 2RvY3VtZW50LzY3MDY0NTQ= [retrieved on 2025-02-20] * page 5; figure 8 * | 1-15 | |
| A | US 2023/247206 A1 (PERINGASSERY KRISHNAN MADHU [US] ET AL) 3 August 2023 (2023-08-03) * paragraphs [0023], [0024]; claims 1,11 * | 1-15 | TECHNICAL FIELDS SEARCHED (IPC) H04N H03M |
| A | US 2023/254511 A1 (ZHAO XIN [US] ET AL) 10 August 2023 (2023-08-10) * paragraphs [0170] - [0174], [0185] * | 1-15 | |

-/--

The present search report has been drawn up for all claims

| Place of search | Date of completion of the search | Examiner |
|---|---|---|
| Munich | 21 February 2025 | McGrath, Simon |

CATEGORY OF CITED DOCUMENTS

X : particularly relevant if taken alone
Y : particularly relevant if combined with another
document of the same category
A : technological background
O : non-written disclosure
P : intermediate document

T : theory or principle underlying the invention
E : earlier patent document, but published on, or after the filing date
D : document cited in the application
L : document cited for other reasons
&  : member of the same patent family, corresponding document

EPO FORM 1503 03.82 (P04C01)

page 1 of 2

Europäisches
Patentamt

European
Patent Office

Office européen
des brevets

# EUROPEAN SEARCH REPORT

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| A | CHAN KA-HOU ET AL: "Using Four Hypothesis Probability Estimators for CABAC in Versatile Video Coding", ACM TRANSACTIONS ON MULTIMEDIA COMPUTING COMMUNICATIONS ANDAPPLICATIONS, ASSOCIATION FOR COMPUTING MACHINERY, US, vol. 19, no. 1s, 23 January 2023 (2023-01-23), pages 1-17, XP059190855, ISSN: 1551-6857, DOI: 10.1145/3531015 * the whole document * | 1-15 | |
| | ----- | | |

TECHNICAL FIELDS
SEARCHED      (IPC)

The present search report has been drawn up for all claims

| Place of search | Date of completion of the search | Examiner |
|---|---|---|
| Munich | 21 February 2025 | McGrath, Simon |

CATEGORY OF CITED DOCUMENTS

X : particularly relevant if taken alone
Y : particularly relevant if combined with another
    document of the same category
A : technological background
O : non-written disclosure
P : intermediate document

T : theory or principle underlying the invention
E : earlier patent document, but published on, or
    after the filing date
D : document cited in the application
L : document cited for other reasons
...............................................................................
& : member of the same patent family, corresponding
    document

EPO FORM 1503 03.82 (P04C01)

## ANNEX TO THE EUROPEAN SEARCH REPORT
## ON EUROPEAN PATENT APPLICATION NO.

EP 24 20 3465

This annex lists the patent family members relating to the patent documents cited in the above-mentioned European search report.
The members are as contained in the European Patent Office EDP file on
The European Patent Office is in no way liable for these particulars which are merely given for the purpose of information.

21-02-2025

| Patent document cited in search report | Publication date | Patent family member(s) | Publication date |
|---|---|---|---|
| US 2023247206 A1 | 03-08-2023 | CN 117044204 A | 10-11-2023 |
| | | EP 4473733 A1 | 11-12-2024 |
| | | JP 2024515888 A | 10-04-2024 |
| | | KR 20230158118 A | 17-11-2023 |
| | | US 2023247206 A1 | 03-08-2023 |
| | | WO 2023149923 A1 | 10-08-2023 |
| US 2023254511 A1 | 10-08-2023 | CN 116982263 A | 31-10-2023 |
| | | EP 4473664 A1 | 11-12-2024 |
| | | JP 2024512662 A | 19-03-2024 |
| | | KR 20230162068 A | 28-11-2023 |
| | | US 2023254511 A1 | 10-08-2023 |
| | | WO 2023149980 A1 | 10-08-2023 |

EPO FORM P0459